# EUROPEAN PATENT APPLICATION

(11) **EP 3 747 954 A1**
(43) Date of publication of application: **09.12.2020**
(21) Application number: 19748131.0
(22) Date of filing: 31.01.2019
(51) Int. Cl.: C08L 101/00, C08K 5/13, G03F 7/004, G03F 7/039, G03F 7/20

(54) **COMPOSITION, RESIST-PATTERN FORMING METHOD, AND INSULATING-FILM FORMING METHOD**

(30) Priority: 31.01.2018 JP 2018015335
(71) Applicant: MITSUBISHI GAS CHEMICAL COMPANY, INC., Chiyoda-ku Tokyo 100-8324 (JP)
(72) Inventor: SATO, Takashi, Hiratsuka-shi, Kanagawa 254-0016 (JP); ECHIGO, Masatoshi, Tokyo 100-8324 (JP)
(74) Representative: Müller-Boré & Partner Patentanwälte PartG mbB
(86) International application number: PCT/JP2019/003406
(87) International publication number: WO 2019/151403

(57) **Abstract**

The present invention provides a composition capable of forming a film having high etching resistance, as well as a method for forming a resist pattern and a method for forming an insulating film, using the composition.

A composition comprising a base material (A) and a polyphenol compound (B), wherein the mass ratio between the base material (A) and the polyphenol compound (B) is 5:95 to 95:5.

A method for forming an insulating film, comprising the step of: developing the photoresist layer after the radiation irradiation.

## Description

### Technical Field

The present invention relates to a composition, as well as a method for forming a resist pattern and a method for forming an insulating film, and in particular, relates to a composition used for film formation purposes for lithography and film formation purposes for resist, and a film formation method using the same.

### Background Art

In recent years, in the production of semiconductor elements and liquid crystal display elements, semiconductors (patterns) and pixels have been rapidly miniaturized due to the advance in lithography technology. As an approach for pixel miniaturization, the exposure light source has been shifted to have a shorter wavelength, in general. Specifically, ultraviolet rays typified by g-ray and i-ray have been used conventionally, but nowadays, far ultraviolet exposure such as KrF excimer laser (248 nm) and ArF excimer laser (193 nm) is being the center of mass production. Furthermore, the introduction of extreme ultraviolet (EUV) lithography (13.5 nm) is progressing. In addition, electron beam (EB) is also used for forming a fine pattern.

Up to now, typical resist materials are polymer based resist materials capable of forming an amorphous film. Examples include polymer based resist materials such as polymethyl methacrylate, polyhydroxy styrene with an acid dissociation group, and polyalkyl methacrylate (see, for example, Non Patent Literature 1).

Conventionally, a line pattern of about 10 to 100 nm is formed by irradiating a resist thin film made by coating a substrate with a solution of these resist materials with ultraviolet, far ultraviolet, electron beam, extreme ultraviolet or the like.

In addition, lithography using electron beam or extreme ultraviolet has a reaction mechanism different from that of normal photolithography. Furthermore, lithography with electron beam or extreme ultraviolet aims at forming fine patterns of several nm to ten-odd nm. Accordingly, there is a demand for a resist material having higher sensitivity for an exposing source when the resist pattern dimension is reduced. In particular, lithography with extreme ultraviolet is required to further increase sensitivity in terms of throughput.

As a resist material that solves the problems as mentioned above, an inorganic resist material having a metallic element such as titanium, tin, hafnium and zirconium has been proposed (see, for example, Patent Literature 1).

### Citation List

### Patent Literature

Patent Literature 1: Japanese Patent Laid-Open No. 2015-108781

### Non Patent Literature

Non Patent Literature 1: Shinji Okazaki et al., "Development of Lithography Technology in These 40 Years", S&T Publishing Inc., December 9, 2016

### Summary of Invention

### Technical Problem

However, conventionally developed resist compositions have problems such as many film defects, insufficient sensitivity, insufficient etching resistance, or poor resist pattern. In particular, for producing a 3D NAND device, it is necessary to form a thick resist, and there is an urgent need to solve these problems (in particular, insufficient etching resistance).

The present invention has an object to provide a composition capable of forming a film having high etching resistance, as well as a method for forming a resist pattern and a method for forming an insulating film, using the composition.

### Solution to Problem

The inventors have, as a result of devoted examinations to solve the problems mentioned above, found out that a compound and resin having a specific structure have high solubility in a safe solvent, and are capable of forming a film having high etching resistance when the compound and the like are used in a composition for film formation purposes for photography or film formation purposes for resist, leading to completion of the present invention.

More specifically, the present invention is as follows.
<1> A composition comprising a base material (A) and a polyphenol compound (B), wherein a mass ratio between the base material (A) and the polyphenol compound (B) is 5:95 to 95:5.
<2> The composition according to the above <1>, wherein the base material (A) is selected from the group consisting of a phenol novolac resin, a cresol novolac resin, a hydroxystyrene resin, a (meth)acrylic resin, a hydroxystyrene-(meth)acrylic copolymer, a cycloolefin-maleic anhydride copolymer, a cycloolefin, a vinyl ether-maleic anhydride copolymer and an inorganic resist material having a metallic element, and a derivative thereof.
<3> The composition according to the above <1> or <2>, wherein the polyphenol compound (B) is selected from a compound represented by the following formula (1) and a resin having a structure represented by the following formula (2): 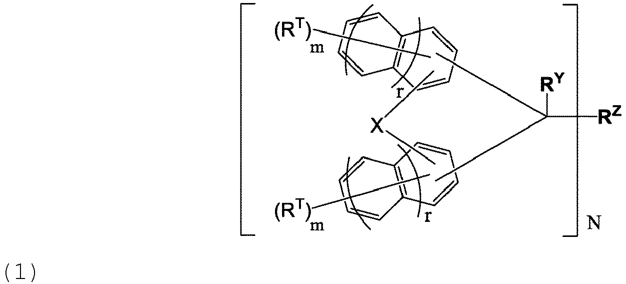
   wherein R^{Y} is a hydrogen atom, an alkyl group having 1 to 30 carbon atoms and optionally having a substituent, or an aryl group having 6 to 30 carbon atoms and optionally having a substituent;
   R^{Z} is an N-valent group having 1 to 60 carbon atoms and optionally having a substituent, or a single bond;
   each R^{T} is independently an alkyl group having 1 to 30 carbon atoms and optionally having a substituent, an aryl group having 6 to 30 carbon atoms and optionally having a substituent, an alkenyl group having 2 to 30 carbon atoms and optionally having a substituent, an alkynyl group having 2 to 30 carbon atoms and optionally having a substituent, an alkoxy group having 1 to 30 carbon atoms and optionally having a substituent, a halogen atom, a nitro group, an amino group, a carboxylic acid group, a crosslinkable group, a dissociation group, a thiol group, or a hydroxy group (provided that at least one R^{T} contains a crosslinkable group, a dissociation group or a hydroxy group), wherein the alkyl group, the aryl group, the alkenyl group, the alkynyl group and the alkoxy group each optionally contain an ether bond, a ketone bond or an ester bond;
   X is an oxygen atom, a sulfur atom or not a crosslink;
   each m is independently an integer of 0 to 9 (provided that at least one m is an integer of 1 to 9);
   N is an integer of 1 to 4 (provided that when N is an integer of 2 or larger, N structural formulas within the parentheses [ ] are the same or different); and
   each r is independently an integer of 0 to 2, and 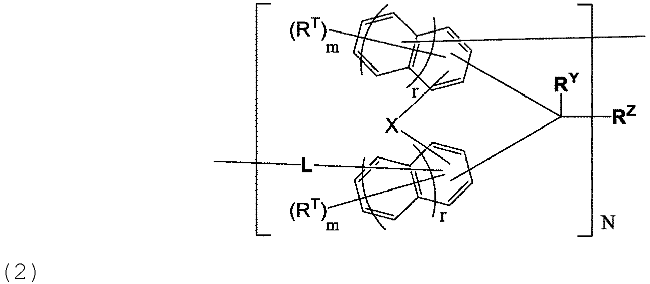
   wherein L is an alkylene group having 1 to 30 carbon atoms and optionally having a substituent, an arylene group having 6 to 30 carbon atoms and optionally having a substituent, an alkoxylene group having 1 to 30 carbon atoms and optionally having a substituent, or a single bond, wherein the alkylene group, the arylene group and the alkoxylene group each optionally contain an ether bond, a ketone bond or an ester bond;
   R^{Y} is a hydrogen atom, an alkyl group having 1 to 30 carbon atoms or an aryl group having 6 to 30 carbon atoms;
   R^{Z} is an N-valent group having 1 to 60 carbon atoms or a single bond;
   each R^{T} is independently an alkyl group having 1 to 30 carbon atoms and optionally having a substituent, an aryl group having 6 to 30 carbon atoms and optionally having a substituent, an alkenyl group having 2 to 30 carbon atoms and optionally having a substituent, an alkynyl group having 2 to 30 carbon atoms and optionally having a substituent, an alkoxy group having 1 to 30 carbon atoms and optionally having a substituent, a halogen atom, a nitro group, an amino group, a carboxylic acid group, a crosslinkable group, a dissociation group, a thiol group, or a hydroxy group (provided that at least one R^{T} contains a crosslinkable group, a dissociation group or a hydroxy group), wherein the alkyl group, the aryl group, the alkenyl group, the alkynyl group and the alkoxy group each optionally contain an ether bond, a ketone bond or an ester bond;
   X is an oxygen atom, a sulfur atom or not a crosslink;
   each m is independently an integer of 0 to 9 (provided that at least one m is an integer of 1 to 9);
   N is an integer of 1 to 4 (provided that when N is an integer of 2 or larger, N structural formulas within the parentheses [ ] are the same or different); and
   each r is independently an integer of 0 to 2.
<4> The composition according to any one of the above <1> to <3>, wherein the mass ratio between the base material (A) and the polyphenol compound (B) is 51:49 to 95:5.
<5> The composition according to any one of the above <1> to <4>, further comprising an acid generating agent.
<6> The composition according to any one of the above <1> to <5>, further comprising a crosslinking agent.
<7> The composition according to any one of the above <1> to <6>, further comprising a solvent.
<8> The composition according to any one of the above <1> to <7>, wherein the composition is used in film formation for lithography.
<9> The composition according to any one of the above <1> to <7>, wherein the composition is used in film formation for resist.
<10> The composition according to the above <3>, wherein the compound represented by the above formula (1) is a compound represented by the following formula (3): 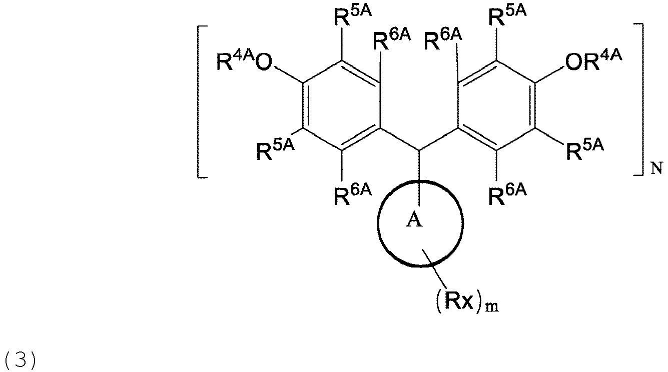 wherein A is an N-valent group having 1 to 60 carbon atoms and optionally having a substituent, and each Rx is independently an alkyl group having 1 to 30 carbon atoms and optionally having a substituent, an aryl group having 6 to 30 carbon atoms and optionally having a substituent, an alkenyl group having 2 to 30 carbon atoms and optionally having a substituent, an alkynyl group optionally having a substituent, an alkoxy group having 1 to 30 carbon atoms and optionally having a substituent, a halogen atom, a nitro group, an amino group, a carboxylic acid group, a crosslinkable group, a dissociation group, a thiol group, or a hydroxy group (provided that at least one Rx contains iodine); each R^{4A} is independently a dissociation group, a crosslinkable group or a hydrogen atom, each R^{5A} is independently an alkyl group having 1 to 30 carbon atoms and optionally having a substituent, an aryl group having 6 to 30 carbon atoms and optionally having a substituent, an alkenyl group having 2 to 30 carbon atoms and optionally having a substituent, an alkynyl group optionally having a substituent, an alkoxy group having 1 to 30 carbon atoms and optionally having a substituent, a halogen atom, a nitro group, an amino group, a carboxylic acid group, a crosslinkable group, a dissociation group, a thiol group, or a hydroxy group, and each R^{6A} is independently a hydrogen atom, an alkyl group having 1 to 30 carbon atoms and optionally having a substituent, an aryl group having 6 to 30 carbon atoms and optionally having a substituent, an alkenyl group having 2 to 30 carbon atoms and optionally having a substituent, an alkynyl group optionally having a substituent, an alkoxy group having 1 to 30 carbon atoms and optionally having a substituent, a halogen atom, a nitro group, an amino group, a carboxylic acid group, a crosslinkable group, a dissociation group, a thiol group, or a hydroxy group;
   each m is independently an integer of 1 to 20; and N is as defined in the description of the above formula (1).
<11> A method for forming a resist pattern, comprising the steps of: forming a photoresist layer on a substrate using the composition according to any one of the above <1> to <7>; irradiating a predetermined region of the photoresist layer formed on the substrate with radiation; and developing the photoresist layer after the radiation irradiation.
<12> A method for forming an insulating film, comprising the steps of: forming a photoresist layer on a substrate using the composition according to any one of the above <1> to <7>; irradiating a predetermined region of the photoresist layer formed on the substrate with radiation; and developing the photoresist layer after the radiation irradiation.

### Advantageous Effects of Invention

According to the present invention, it has an object to provide a composition capable of forming a film having high etching resistance, as well as a method for forming a resist pattern and a method for forming an insulating film, using the composition.

### Description of Embodiments

Hereinafter, an embodiment of the present invention will be described (hereinafter, may be referred to as the "present embodiment"). The present embodiment is given in order to illustrate the present invention. The present invention is not limited to only the present embodiment.

A composition of the present embodiment contains a base material (A) and a polyphenol compound (B), and the mass ratio between the base material (A) and the polyphenol compound (B) [A:B] is 5:95 to 95:5. The composition of the present embodiment is a composition that can be used for lithography technology, and can be used for, without particular limitation, film formation purposes for lithography, for example, resist film formation purposes (that is, a "resist composition"). Furthermore, the composition of the present embodiment can be used for upper layer film formation purposes (that is, a "composition for upper layer film formation"), intermediate layer formation purposes (that is, a "composition for intermediate layer formation"), underlayer film formation purposes (that is, a "composition for underlayer film formation"), and the like. According to the composition of the present embodiment, not only a film having high etching resistance can be formed, but also the composition can achieve higher sensitivity and can also impart a good shape to a resist pattern.

The composition of the present embodiment can also be used as an optical component forming composition applying lithography technology. The optical component is used in the form of a film or a sheet and is also useful as a plastic lens (a prism lens, a lenticular lens, a microlens, a Fresnel lens, a viewing angle control lens, a contrast improving lens, etc.), a phase difference film, a film for electromagnetic wave shielding, a prism, an optical fiber, a solder resist for flexible printed wiring, a plating resist, an interlayer insulating film for multilayer printed circuit boards, a photosensitive optical waveguide, a liquid crystal display, an organic electroluminescent (EL) display, an optical semiconductor (LED) element, a solid state image sensing element, an organic thin film solar cell, a dye sensitized solar cell, and an organic thin film transistor (TFT). It can be particularly suitably utilized as an embedded film and a smoothed film on a photodiode, a smoothed film in front of or behind a color filter, a microlens, and a smoothed film and a conformal film on a microlens, all of which are components of a solid state image sensing element, to which high refractive index is demanded.

### <<Composition>>

A composition of the present embodiment contains a base material (A) and a polyphenol compound (B), and the mass ratio between the base material (A) and the polyphenol compound (B) [A:B] is 5:95 to 95:5. The composition of the present embodiment may also contain other components such as a solvent (S), an acid generating agent (C), a crosslinking agent (G), and an acid diffusion controlling agent (E), in addition to the base material (A) and the polyphenol compound (B), if required. Hereinafter, each of these components will be described.

### [Base material (A)]

The "base material (A)" in the present embodiment is a compound (including a resin) other than the polyphenol compound, which will be mentioned later, and means a base material applied as a resist for g-ray, i-ray, KrF excimer laser (248 nm), ArF excimer laser (193 nm), extreme ultraviolet (EUV) lithography (13.5 nm) or electron beam (EB) (for example, a base material for lithography or a base material for resist). These base materials can be used as the base material (A) according to the present embodiment without particular limitation. Examples of the base material (A) include a phenolic hydroxy group containing resin such as a phenol novolac resin, a cresol novolac resin, a hydroxystyrene resin and a hydroxystyrene-(meth)acrylic copolymer, a (meth)acrylic resin, a cycloolefin-maleic anhydride copolymer, a cycloolefin, a vinyl ether-maleic anhydride copolymer, and an inorganic resist material having a metallic element such as titanium, tin, hafnium and zirconium, and a derivative thereof. Among them, from the viewpoint of the shape of a resist pattern to be obtained, preferable are a phenolic hydroxy group containing resin such as a phenol novolac resin, a cresol novolac resin and a hydroxystyrene-(meth)acrylic copolymer, a hydroxystyrene resin, a (meth)acrylic resin, and an inorganic resist material having a metallic element such as titanium, tin, hafnium and zirconium, and a derivative thereof.

Examples of the above derivative include, but not limited to, those to which a dissociation group is introduced and those to which a crosslinkable group is introduced. The above derivative to which a dissociation group or a crosslinkable group is introduced can exhibit dissociation reaction or crosslinking reaction through the effect of light, acid or the like. Examples of the dissociation group and the crosslinkable group can include the same as those described in the polyphenol compound (B), which will be mentioned later.

In the present embodiment, the weight average molecular weight of the base material (A) can be 200 to 20,000, and is preferably 200 to 4990, still more preferably 200 to 2990, and particularly preferably 200 to 1490 from the viewpoints of reducing defects in a film to be formed by using the composition and of a good pattern shape. As the above weight average molecular weight, a value obtained by measuring the weight average molecular weight in terms of polystyrene, using GPC, can be used.

The above phenolic hydroxy group containing resin, which can be used as the base material (A) according to the present embodiment, is not particularly limited as long as it is a resin obtained from condensation between a phenol and a carbonyl compound, and a derivative thereof.

Among the above phenolic hydroxy group containing resins that can be used as the base material (A) according to the present embodiment, preferable are a cresol novolac resin and a hydroxystyrene resin from the viewpoint of heat resistance. Specifically, the cresol novolac resin is a novolac resin obtained by using at least one cresol selected from o-cresol, m-cresol and p-cresol, and an aldehyde compound as raw materials.

In addition, the above hydroxystyrene resin, which can be used as the base material (A), is not particularly limited as long as it is an alkali soluble resin, and examples thereof include a poly(4-hydroxystyrene), a poly(3-hydroxystyrene), a poly(2-hydroxystyrene), and a copolymer of a hydroxy group containing styrene compound.

In addition, examples of the above (meth)acrylic resin, which can be used as the base material (A), include resins obtained by polymerizing a monomer such as methyl (meth)acrylate, ethyl (meth)acrylate, 2-ethylhexyl (meth)acrylate, n-nonyl (meth)acrylate, (meth)acrylic acid and glycidyl (meth)acrylate alone.

In addition, examples of the above cycloolefin, which can be used as the base material (A), include cyclopentadiene, dicyclopentadiene and norbornadiene.

In the present embodiment, the mass ratio between the base material (A) and the polyphenol compound (B) [base material (A):polyphenol compound (B)] is 5:95 to 95:5. When the mass ratio between the base material (A) and the polyphenol compound (B) is out of this range, the etching resistance is lowered, and the number of defects in the film is also increased and a resist pattern to be obtained is deteriorated. Also, the above mass ratio is preferably 31:69 to 95:5, and still more preferably 51:49 to 95:5 from the viewpoints of reducing defects and of etching resistance.

### [Polyphenol compound (B)]

In the present embodiment, the polyphenol compound (B) is a compound having a plurality of phenolic hydroxy group compounds in the molecule. It is preferable that the polyphenol compound (B) be a compound represented by the following formula (1) or a resin having a structure represented by the following formula (2).

The polyphenol compound (B) has a high affinity with the base material (A), high heat resistance, low glass transition temperature, low molecular weight, and high etching resistance, and is therefore used in a resist composition or the like that is capable of reducing film defects, has high sensitivity, and can impart a good shape to a resist pattern.

It is preferable that the polyphenol compound (B) according to the present embodiment have a monovalent group containing a halogen atom. When the polyphenol compound (B) has a monovalent group containing a halogen atom, absorption of extreme ultraviolet (EUV) can be increased and a sensitization effect of EUV can be exhibited. As the halogen atom, fluorine, bromo and iodine are preferable. From the viewpoint of enhancing the sensitization ability, fluorine and iodine are preferable, and among them, iodine has the highest sensitization effect and is preferable.

Examples of the monovalent group containing a halogen atom include, but not particularly limited to, a linear hydrocarbon group having 1 to 30 carbon atoms and substituted with a halogen atom, a branched hydrocarbon group having 3 to 30 carbon atoms and substituted with a halogen atom, an alicyclic hydrocarbon group having 3 to 30 carbon atoms and substituted with a halogen atom, an aromatic group having 6 to 30 carbon atoms and substituted with a halogen atom, and a group having an aromatic group having 6 to 30 carbon atoms and substituted with a halogen atom. Among the above, from the viewpoint of heat resistance, a branched hydrocarbon group having 3 to 30 carbon atoms and substituted with a halogen atom, an alicyclic hydrocarbon group having 3 to 30 carbon atoms and substituted with a halogen atom, an aromatic group having 6 to 30 carbon atoms and substituted with a halogen atom, or a group having an aromatic group having 6 to 30 carbon atoms and substituted with a halogen atom is preferable; an alicyclic hydrocarbon group having 3 to 30 carbon atoms and substituted with a halogen atom, an aromatic group having 6 to 30 carbon atoms and substituted with a halogen atom, or a group having an aromatic group having 6 to 30 carbon atoms and substituted with a halogen atom is more preferable; and a group having an aromatic group having 6 to 30 carbon atoms and substituted with a halogen atom is still more preferable.

Preferable examples of the monovalent group containing a halogen atom include a fluoro group, a fluoromethyl group, a difluoromethyl group, a trifluoromethyl group, a hydroxyhexafluoropropyl group, a chloro group, a chloromethyl group, a dichloromethyl group, a trichloromethyl group, a hydroxyhexachloropropyl group, a bromo group, a bromomethyl group, a dibromomethyl group, a tribromomethyl group, a hydroxyhexabromopropyl group, a iodo group, a iodomethyl group, a diiodomethyl group, a triiodomethyl group, and a hydroxyhexaiodopropyl group.

In the present specification, unless otherwise defined, the term "substituted" means that one or more hydrogen atoms in a functional group are substituted with a substituent. Examples of the "substituent" include a halogen atom, a hydroxy group, a cyano group, a nitro group, an amino group, a thiol group, a heterocyclic group, a linear aliphatic hydrocarbon group having 1 to 20 carbon atoms, a branched aliphatic hydrocarbon group having 3 to 20 carbon atoms, a cyclic aliphatic hydrocarbon group having 3 to 20 carbon atoms, an aryl group having 6 to 20 carbon atoms, an aralkyl group having 7 to 30 carbon atoms, an alkoxy group having 1 to 20 carbon atoms, an amino group having 0 to 20 carbon atoms, an alkenyl group having 2 to 20 carbon atoms, an acyl group having 1 to 20 carbon atoms, an alkoxycarbonyl group having 2 to 20 carbon atoms, an alkyloyloxy group having 1 to 20 carbon atoms, an aryloyloxy group having 7 to 30 carbon atoms, and an alkylsilyl group having 1 to 20 carbon atoms.

It is preferable that the polyphenol compound (B) according to the present embodiment be derivatized for use. Through such derivatization, an even better shape can be imparted to a resist pattern. The above derivatization is not limited, but examples thereof include introduction of a dissociation group and introduction of a crosslinkable group, and a polyphenol compound (B) to which these groups are introduced can exhibit dissociation reaction or crosslinking reaction through the effect of light, acid or the like.

Here, the "dissociation group" refers to a group that is dissociated in the presence of a catalyst or without a catalyst. An acid dissociation group refers to a characteristic group that is cleaved in the presence of an acid to cause a change in an alkali soluble group or the like. Examples of the alkali soluble group include, but not particularly limited to, a group having a phenolic hydroxy group, a group having a carboxyl group, a group having a sulfonic acid group, and a group having a hexafluoroisopropanol group. Among them, a phenolic hydroxy group and a carboxyl group are preferable, and a phenolic hydroxy group is particularly preferable, from the viewpoint of the easy availability of an introduction reagent. It is preferable that the acid dissociation group have the property of causing chained cleavage reaction in the presence of an acid, for achieving pattern formation with high sensitivity and high resolution. The acid dissociation group is not particularly limited, but can be arbitrarily selected for use from among, for example, those proposed in hydroxystyrene resins, (meth)acrylic acid resins, and the like for use in chemically amplified resist compositions for KrF or ArF.

Preferable examples of the acid dissociation group include a group selected from the group consisting of a 1-substituted ethyl group, a 1-substituted n-propyl group, a 1-branched alkyl group, a silyl group, an acyl group, a 1-substituted alkoxymethyl group, a cyclic ether group, an alkoxycarbonyl group, and an alkoxycarbonylalkyl group, which have the property of being dissociated by an acid.

The "crosslinkable" group according to the present embodiment refers to a group that crosslinks in the presence of a catalyst or without a catalyst. Examples of the crosslinkable group include, but not particularly limited to, an alkoxy group having 1 to 20 carbon atoms, a group having an allyl group, a group having a (meth)acryloyl group, a group having an epoxy (meth)acryloyl group, a group having a hydroxy group, a group having a urethane (meth)acryloyl group, a group having a glycidyl group, a group having a vinyl containing phenylmethyl group, a group having a group having various alkynyl groups, a group having a carbon-carbon double bond, a group having a carbon-carbon triple bond, and a group containing these groups. Suitable examples of the above group containing these groups include an alkoxy group of the groups mentioned above - OR^{X} (R^{X} is a group having an allyl group, a group having a (meth)acryloyl group, a group having an epoxy (meth)acryloyl group, a group having a hydroxy group, a group having a urethane (meth)acryloyl group, a group having a glycidyl group, a group having a vinyl containing phenylmethyl group, a group having a group having various alkynyl groups, a group having a carbon-carbon double bond, a group having a carbon-carbon triple bond, or a group containing these groups).

Examples of the group having an allyl group include, but not particularly limited to, a group represented by the following formula (X-1). 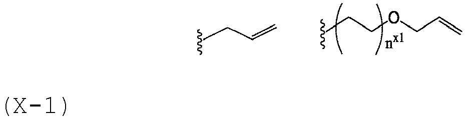 (In the formula (X-1), n^{X1} is an integer of 1 to 5.)

Examples of the group having a (meth)acryloyl group include, but not particularly limited to, a group represented by the following formula (X-2). 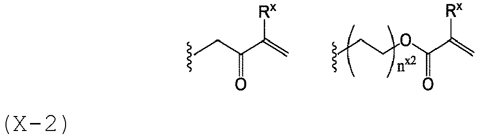 (In the formula (X-2), n^{X2} is an integer of 1 to 5, and R^{X} is a hydrogen atom or a methyl group.)

Examples of the group having an epoxy (meth)acryloyl group include, but not particularly limited to, a group represented by the following formula (X-3). Here, the epoxy (meth)acryloyl group is a group generated through a reaction between an epoxy (meth)acrylate and a hydroxy group. 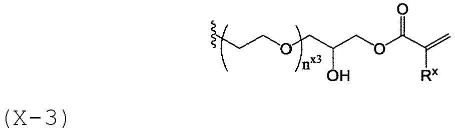 (In the formula (X-3), n^{X3} is an integer of 0 to 5, and R^{X} is a hydrogen atom or a methyl group.)

Examples of the group having a urethane (meth)acryloyl group include, but not particularly limited to, a group represented by the following formula (X-4). 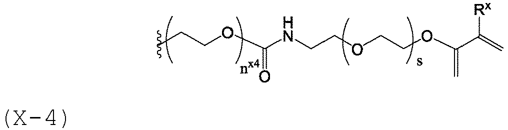 (In the general formula (X-4), n^{X4} is an integer of 0 to 5, s is an integer of 0 to 3, and R^{X} is a hydrogen atom or a methyl group.)

Examples of the group having a hydroxy group include, but not particularly limited to, a group represented by the following formula (X-5). 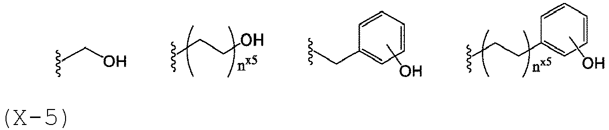 (In the general formula (X-5), n^{x5} is an integer of 1 to 5.)

Examples of the group having a glycidyl group include, but not particularly limited to, a group represented by the following formula (X-6). 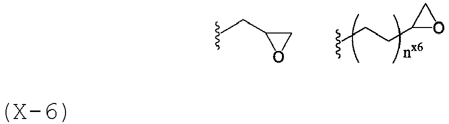 (In the formula (X-6), n^{x6} is an integer of 1 to 5.)

Examples of the group having a vinyl containing phenylmethyl group include, but not particularly limited to, a group represented by the following formula (X-7). 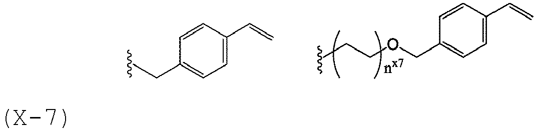 (In the formula (X-7), n^{x7} is an integer of 1 to 5.)

Examples of the group having various alkynyl groups include, but not particularly limited to, a group represented by the following formula (X-8). 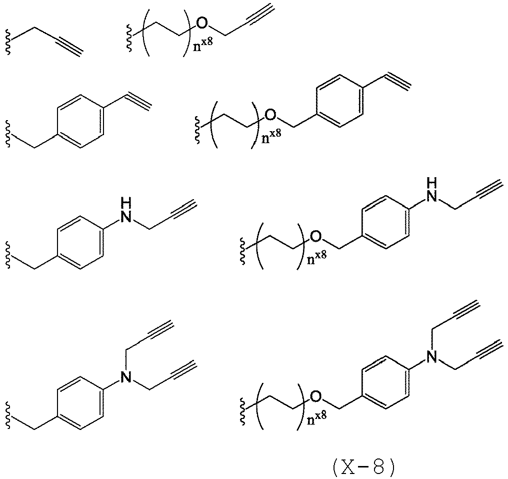 (In the formula (X-8), n^{x8} is an integer of 1 to 5.)

Examples of the above carbon-carbon double bond containing group include a (meth)acryloyl group, a substituted or unsubstituted vinyl phenyl group, and a group represented by the following formula (X-9-1). In addition, examples of the above carbon-carbon-triple bond containing group include a substituted or unsubstituted ethynyl group, a substituted or unsubstituted propargyl group, and a group represented by the following formula (X-9-2) or (X-9-3).

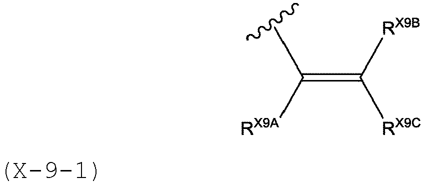

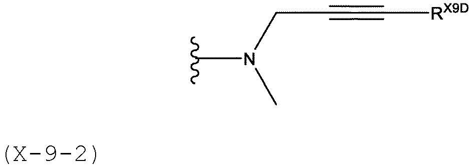

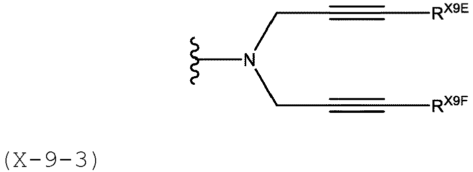

In the above formula (X-9-1), R^{X9A}, R^{X9B} and R^{X9C} are each independently a hydrogen atom or a monovalent hydrocarbon group having 1 to 20 carbon atoms. In the above formulas (X-9-2) and (X-9-3), R^{X9D}, R^{X9E} and R^{X9F} are each independently a hydrogen atom or a monovalent hydrocarbon group having 1 to 20 carbon atoms.

Among the above, from the viewpoint of ultraviolet curability, a (meth)acryloyl group, an epoxy (meth)acryloyl group, a urethane (meth)acryloyl group, a group having a glycidyl group, and a group containing a styrene group are preferable, a (meth)acryloyl group, an epoxy (meth)acryloyl group and a urethane (meth)acryloyl group are more preferable, and a (meth)acryloyl group is still more preferable. In addition, from the viewpoint of heat resistance, a group having various alkynyl groups is also preferable.

When the composition of the present embodiment is a positive type, at least any of the base material (A) and the polyphenol compound (B) has a dissociation group, or an additive agent that causes a change in the solubility in a developing solution due to the effect of exposure can be used in combination. Similarly, when the composition of the present embodiment is a negative type, a separate crosslinking agent may be used in combination, or at least any of the base material (A) and the polyphenol compound (B) may have a crosslinkable group.

### (Compound represented by formula (1))

In the present embodiment, as the polyphenol compound (B), a compound represented by the following formula (1) can be used. The compound represented by the formula (1) has high heat resistance attributed to its rigid structure, in spite of its relatively low molecular weight, and can therefore be used even under high temperature baking conditions. Also, the compound represented by the formula (1) has tertiary carbon or quaternary carbon in the molecule, which inhibits crystallinity, and is thus suitably used as a composition for lithography or a resist composition that is used in production of a film for lithography or a film for resist.

In the present embodiment, the molecular weight of the compound represented by the formula (1) is preferably 200 to 9900, still more preferably 200 to 4900, and particularly preferably 200 to 2900 from the viewpoints of reducing defects in a film to be formed by using the composition and of a good pattern shape. As the above weight average molecular weight, a value obtained by measuring the weight average molecular weight in terms of polystyrene, using GPC, can be used.

In addition, the compound represented by the following formula (1) has high solubility in a safe solvent and has good heat resistance and etching resistance. Therefore, when a composition containing such a compound is used to form a film, a resist pattern with a good shape can be obtained. Furthermore, the compound represented by the formula (1) is a compound that has a relatively high carbon concentration, and can therefore also impart high etching resistance to a film to be obtained by using this compound. 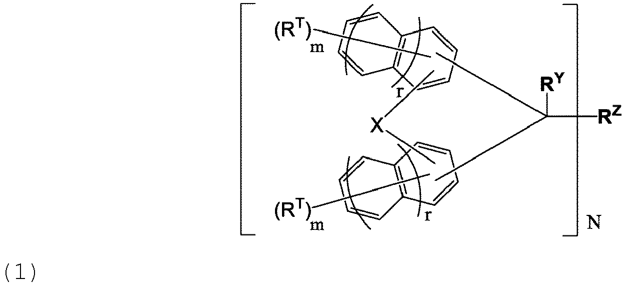 (In the formula (1), R^{Y} is a hydrogen atom, an alkyl group having 1 to 30 carbon atoms and optionally having a substituent, or an aryl group having 6 to 30 carbon atoms and optionally having a substituent;
R^{Z} is an N-valent group having 1 to 60 carbon atoms and optionally having a substituent, or a single bond;
each R^{T} is independently an alkyl group having 1 to 30 carbon atoms and optionally having a substituent, an aryl group having 6 to 30 carbon atoms and optionally having a substituent, an alkenyl group having 2 to 30 carbon atoms and optionally having a substituent, an alkynyl group having 2 to 30 carbon atoms and optionally having a substituent, an alkoxy group having 1 to 30 carbon atoms and optionally having a substituent, a halogen atom, a nitro group, an amino group, a carboxylic acid group, a crosslinkable group, a dissociation group, a thiol group, or a hydroxy group (provided that at least one R^{T} contains a crosslinkable group, a dissociation group or a hydroxy group), wherein the alkyl group, the aryl group, the alkenyl group, the alkynyl group and the alkoxy group each optionally contain an ether bond, a ketone bond or an ester bond;
X is an oxygen atom, a sulfur atom or not a crosslink;
each m is independently an integer of 0 to 9 (provided that at least one m is an integer of 1 to 9);
N is an integer of 1 to 4 (provided that when N is an integer of 2 or larger, N structural formulas within the parentheses [ ] are the same or different); and
each r is independently an integer of 0 to 2.)

In the formula (1), with respect to R^{Y}, the alkyl group having 1 to 30 carbon atoms and optionally having a substituent may be, for example, an unsubstituted methyl group, ethyl group, n-propyl group, i-propyl group, n-butyl group, i-butyl group, t-butyl group, cyclopropyl group, cyclobutyl group or the like, or examples thereof include a methyl group, an ethyl group, a n-propyl group, an i-propyl group, a n-butyl group, an i-butyl group, a t-butyl group, a cyclopropyl group and a cyclobutyl group, having a substituent such as a halogen atom, a nitro group, an amino group, a thiol group, a hydroxy group or a group in which a hydrogen atom of a hydroxy group is replaced with an acid dissociation group.

The aryl group having 6 to 30 carbon atoms and optionally having a substituent may be, for example, an unsubstituted phenyl group, naphthalene group, biphenyl group or the like, or examples thereof include a phenyl group, a naphthalene group and a biphenyl group, having a substituent such as a halogen atom, a nitro group, an amino group, a thiol group, a hydroxy group or a group in which a hydrogen atom of a hydroxy group is replaced with an acid dissociation group.

In the formula (1), with respect to R^{Z}, the above N-valent group refers to an alkyl group having 1 to 60 carbon atoms and optionally having a substituent when N is 1, an alkylene group having 1 to 30 carbon atoms when N is 2, an alkanepropayl group having 2 to 60 carbon atoms when N is 3, and an alkanetetrayl group having 3 to 60 carbon atoms when N is 4. Examples of the above n-valent group include those having a linear hydrocarbon group, a branched hydrocarbon group, or an alicyclic hydrocarbon group. Here, the above alicyclic hydrocarbon group also includes a bridged alicyclic hydrocarbon group. Also, the above N-valent group may have an aromatic group having 6 to 60 carbon atoms.

Also, the above N-valent hydrocarbon group may have an alicyclic hydrocarbon group, a double bond, a heteroatom, or an aromatic group having 6 to 60 carbon atoms. Here, the above alicyclic hydrocarbon group also includes a bridged alicyclic hydrocarbon group.

The group having 6 to 60 carbon atoms and optionally having a substituent may be, for example, an unsubstituted phenyl group, naphthalene group, biphenyl group, anthracyl group, pyrenyl group, cyclohexyl group, cyclododecyl group, dicyclopentyl group, tricyclodecyl group, adamantyl group, phenylene group, naphthalenediyl group, biphenyldiyl group, anthracenediyl group, pyrenediyl group, cyclohexanediyl group, cyclododecanediyl group, dicyclopentanediyl group, tricyclodecanediyl group, adamantanediyl group, benzenetriyl group, naphthalenetriyl group, biphenyltriyl group, anthracenetriyl group, pyrenetriyl group, cyclohexanetriyl group, cyclododecanetriyl group, dicyclopentanetriyl group, tricyclodecanetriyl group, adamantanetriyl group, benzenetetrayl group, naphthalenetetrayl group, biphenyltetrayl group, anthracenetetrayl group, pyrenetetrayl group, cyclohexanetetrayl group, cyclododecanetetrayl group, dicyclopentanetetrayl group, tricyclodecanetetrayl group, adamantanetetrayl group or the like, or alternatively, examples thereof include a phenyl group, a naphthalene group, a biphenyl group, an anthracyl group, a pyrenyl group, a cyclohexyl group, a cyclododecyl group, a dicyclopentyl group, a tricyclodecyl group, an adamantyl group, a phenylene group, a naphthalenediyl group, a biphenyldiyl group, an anthracenediyl group, a pyrenediyl group, a cyclohexanediyl group, a cyclododecanediyl group, a dicyclopentanediyl group, a tricyclodecanediyl group, an adamantanediyl group, a benzenetriyl group, a naphthalenetriyl group, a biphenyltriyl group, an anthracenetriyl group, a pyrenetriyl group, a cyclohexanetriyl group, a cyclododecanetriyl group, a dicyclopentanetriyl group, a tricyclodecanetriyl group, an adamantanetriyl group, a benzenetetrayl group, a naphthalenetetrayl group, a biphenyltetrayl group, an anthracenetetrayl group, a pyrenetetrayl group, a cyclohexanetetrayl group, a cyclododecanetetrayl group, a dicyclopentanetetrayl group, a tricyclodecanetetrayl group and an adamantanetetrayl group, having a substituent such as a halogen atom, a nitro group, an amino group, a thiol group, a hydroxy group or a group in which a hydrogen atom of a hydroxy group is replaced with an acid dissociation group. It is preferable that R^{Z} have at least one unsubstituted or substituted phenyl group, naphthalene group, biphenyl group or cyclohexyl group as the above aromatic group having 6 to 60 carbon atoms from the standpoint of high etching resistance. In addition, from the standpoint of higher sensitivity, it is preferable that R^{Z} have an aromatic group having 6 to 60 carbon atoms and having a halogen atom, it is still more preferable that R^{Z} have at least one phenyl group, naphthalene group, biphenyl group or cyclohexyl group, having a halogen atom, and it is particularly preferable that R^{Z} have at least one phenyl group, naphthalene group, biphenyl group or cyclohexyl group, having an iodine atom.

In the formula (1), R^{T} may be an alkyl group having 1 to 30 carbon atoms and optionally having a substituent, such as an unsubstituted methyl group, ethyl group, n-propyl group, i-propyl group, n-butyl group, i-butyl group, t-butyl group, cyclopropyl group or cyclobutyl group, or alternatively, examples thereof include a methyl group, an ethyl group, a n-propyl group, an i-propyl group, a n-butyl group, an i-butyl group, a t-butyl group, a cyclopropyl group and a cyclobutyl group, having a substituent such as a halogen atom, a nitro group, an amino group, a thiol group, a hydroxy group or a group in which a hydrogen atom of a hydroxy group is replaced with an acid dissociation group.

R^{T} may be an aryl group having 6 to 30 carbon atoms and optionally having a substituent, such as an unsubstituted phenyl group, naphthalene group or biphenyl group, or alternatively, examples thereof include a phenyl group, a naphthalene group and a biphenyl group, having a substituent such as a halogen atom, a nitro group, an amino group, a thiol group, a hydroxy group or a group in which a hydrogen atom of a hydroxy group is replaced with an acid dissociation group.

R^{T} may be an alkenyl group having 2 to 30 carbon atoms and optionally having a substituent, such as an unsubstituted propenyl group or butenyl group, or alternatively, examples thereof include a propenyl group and a butenyl group, having a substituent such as a halogen atom, a nitro group, an amino group, a thiol group, a hydroxy group or a group in which a hydrogen atom of a hydroxy group is replaced with an acid dissociation group.

R^{T} may be an alkynyl group having 2 to 30 carbon atoms and optionally having a substituent, such as an unsubstituted propynyl group or butynyl group, or alternatively, examples thereof include a propynyl group and a butynyl group, having a substituent such as a halogen atom, a nitro group, an amino group, a thiol group, a hydroxy group or a group in which a hydrogen atom of a hydroxy group is replaced with an acid dissociation group.

R^{T} may be an alkoxy group having 1 to 30 carbon atoms and optionally having a substituent, such as an unsubstituted methoxy group, ethoxy group, propoxy group, cyclohexyloxy group, phenoxy group or naphthalenoxy group biphenyl group, or alternatively, examples thereof include a methoxy group, an ethoxy group, a propoxy group, a cyclohexyloxy group, a phenoxy group and a naphthalenoxy group, having a substituent such as a halogen atom, a nitro group, an amino group, a thiol group, a hydroxy group or a group in which a hydrogen atom of a hydroxy group is replaced with an acid dissociation group.

Examples of the crosslinkable group and the dissociation group include those mentioned above.

In the formula (1), when r is 0, the cyclic structure shown in the parentheses is a benzene ring, and when r is 1, the cyclic structure shown in the parentheses is a naphthalene ring. When r is 2, the cyclic structure shown in the parentheses is a tricyclic structure such as an anthracene ring and a phenanthrene ring.

### - Compound represented by formula (1-1) -

In the present embodiment, the compound represented by the formula (1) is preferably a compound represented by the following formula (1-1) from the viewpoint of heat resistance and solvent solubility.

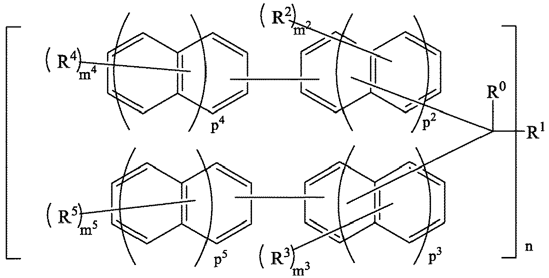

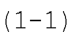

In the above formula (1-1), R⁰ is a hydrogen atom, an alkyl group having 1 to 30 carbon atoms and optionally having a substituent, or an aryl group having 6 to 30 carbon atoms and optionally having a substituent. When R⁰ is a hydrogen atom, a linear, branched or cyclic alkyl group having 1 to 30 carbon atoms and optionally having a substituent, or an aryl group having 6 to 30 carbon atoms and optionally having a substituent, there is a tendency that heat resistance is relatively high and solvent solubility is improved. In addition, R⁰ is preferably a linear, branched or cyclic alkyl group having 1 to 30 carbon atoms or an aryl group having 6 to 30 carbon atoms, from the viewpoint that the compound is prevented from being oxidatively decomposed and stained, and improves heat resistance and solvent solubility.

R¹ is an n-valent group having 1 to 60 carbon atoms or a single bond, and each aromatic ring is bonded via R¹.

R² to R⁵ are each independently an alkyl group having 1 to 30 carbon atoms and optionally having a substituent, an aryl group having 6 to 30 carbon atoms and optionally having a substituent, an alkenyl group having 2 to 30 carbon atoms and optionally having a substituent, an alkynyl group having 2 to 30 carbon atoms and optionally having a substituent, an alkoxy group having 1 to 30 carbon atoms and optionally having a substituent, a halogen atom, a nitro group, an amino group, a carboxylic acid group, a crosslinkable group, a dissociation group, a thiol group, or a hydroxy group, wherein the alkyl group, the aryl group, the alkenyl group, the alkynyl group and the alkoxy group each optionally contain an ether bond, a ketone bond or an ester bond and where at least one of R² to R⁵ contains a dissociation group, a crosslinkable group or a hydroxy group. For the above n-valent group, those that are the same as the N-valent group mentioned above can be used.

m² and m³ are each independently an integer of 0 to 8, and m⁴ and m⁵ are each independently an integer of 0 to 9.

n is an integer of 1 to 4. Here, when n is an integer of 2 or larger, n structural formulas within the parentheses [ ] are the same or different.

p² to p⁵ are each independently an integer of 0 to 2.

Here, each of the alkyl group, the alkenyl group, the alkynyl group and the alkoxy group may be a linear, branched or cyclic group.

The compound represented by the above formula (1-1) has high heat resistance attributed to its rigid structure, in spite of its relatively low molecular weight, and can therefore be used even under high temperature baking conditions. Also, the compound represented by the above formula (1-1) has tertiary carbon or quaternary carbon in the molecule, which inhibits crystallinity, and is thus suitably used as a composition for lithography.

In addition, the compound represented by the above formula (1-1) has high solubility in a safe solvent and has good heat resistance and etching resistance. Therefore, a composition used in film formation for lithography and a composition used in resist film formation, containing the compound represented by the above formula (1-1), can impart an even better shape to a resist pattern. Moreover, the compound represented by the above formula (1-1) has a relatively high carbon concentration and can therefore also impart high etching resistance.

The compound represented by the above formula (1-1) is preferably a compound represented by the following formula (1-1-2) from the viewpoint of easy crosslinking and solubility in an organic solvent.

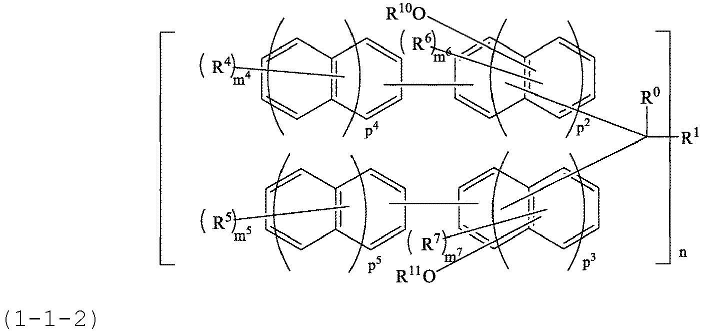

In the formula (1-1-2),
R⁰, R¹, R⁴, R⁵, n, p² to p⁵, m⁴ and m⁵ are as defined above;
R⁶ to R⁷ are each independently an alkyl group having 1 to 30 carbon atoms and optionally having a substituent, an aryl group having 6 to 30 carbon atoms and optionally having a substituent, an alkenyl group having 2 to 30 carbon atoms and optionally having a substituent, an alkynyl group having 2 to 30 carbon atoms and optionally having a substituent, a halogen atom, a nitro group, an amino group, a carboxylic acid group or a thiol group;
R¹⁰ to R¹¹ are each independently a dissociation group, a crosslinkable group or a hydrogen atom; and
m⁶ and m⁷ are each independently an integer of 0 to 7.

In addition, the compound represented by the above formula (1-1-2) is preferably a compound represented by the following formula (1a) from the viewpoint of the supply of raw materials.

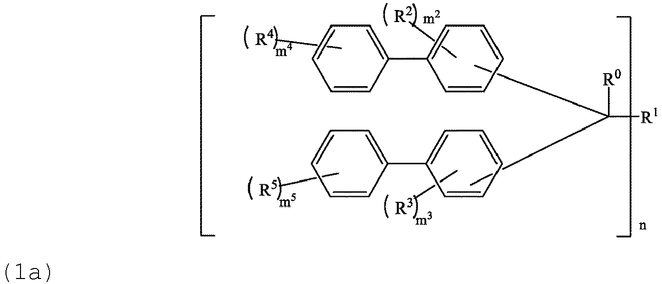

In the above formula (1a), R⁰ to R⁵, m² to m⁵, and n are as defined in the description of the above formula (1-1).

The compound represented by the above formula (1a) is more preferably a compound represented by the following formula (1b) from the viewpoint of solubility in an organic solvent.

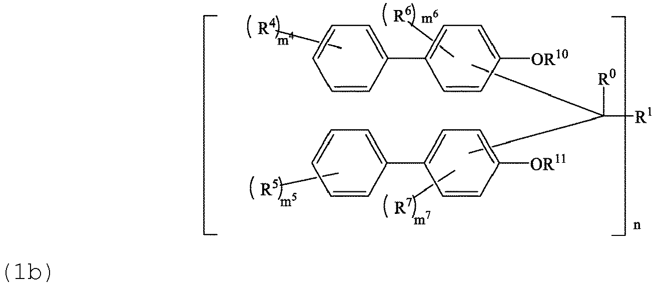

In the above formula (1b), R⁰, R¹, R⁴, R⁵, m⁴, m⁵ and n are as defined in the description of the above formula (1-1), and R⁶, R⁷, R¹⁰, R¹¹, m⁶ and m⁷ are as defined in the description of the above formula (1-1-2).

The compound represented by the above formula (1b) is still more preferably a compound represented by the following formula (1c) from the viewpoint of solubility in an organic solvent.

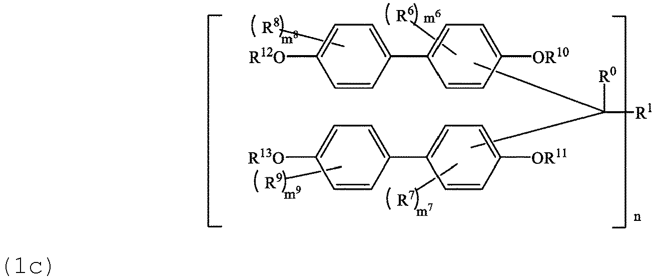

In the above formula (1c), R⁰, R¹, R⁴, R⁵, m⁴, m⁵ and n are as defined in the description of the above formula (1-1), and R⁶, R⁷, R¹⁰, R¹¹, m⁶ and m⁷ are as defined in the description of the above formula (1-1-2). R¹² and R¹³ each independently represent a dissociation group, a crosslinkable group or a hydrogen atom.

The compound represented by the above formula (1) is preferably a compound represented by the following formula (1-2-1) from the viewpoint of easy crosslinking and solubility in an organic solvent.

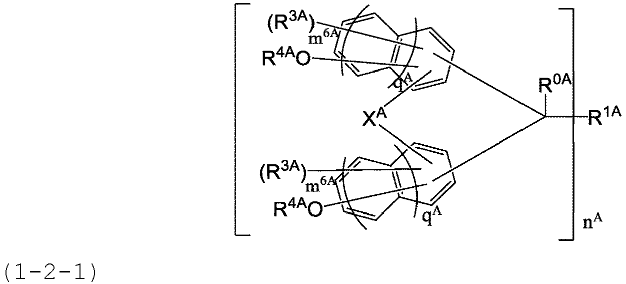

In the formula (1-2-1), each group represents the following.

R^{0A} is a hydrogen atom, an alkyl group having 1 to 30 carbon atoms and optionally having a substituent, or an aryl group having 6 to 30 carbon atoms and optionally having a substituent.

R^{1A} is an n^{A}-valent group having 1 to 60 carbon atoms and optionally having a substituent, or a single bond.

n^{A} is an integer of 1 to 4, where when n^{A} in the formula (1-2) is an integer of 2 or larger, n^{A} structural formulas within the parentheses [ ] are the same or different. For the above n^{A}-valent group, those that are the same as the N-valent group mentioned above can be used.

Each X^{A} is independently an oxygen atom, a sulfur atom or not a crosslink. Here, X^{A} is preferably an oxygen atom or a sulfur atom and more preferably an oxygen atom, because there is a tendency to exhibit excellent heat resistance. Preferably, X^{A} is not a crosslink from the viewpoint of solubility.

Each q^{A} is independently 0 or 1.

R^{3A} is a linear, branched or cyclic alkyl group having 1 to 30 carbon atoms and optionally having a substituent, an aryl group having 6 to 30 carbon atoms and optionally having a substituent, an alkenyl group having 2 to 30 carbon atoms and optionally having a substituent, an alkynyl group having 2 to 30 carbon atoms and optionally having a substituent, a halogen atom, a nitro group, an amino group, a carboxylic acid group or a thiol group, and are the same or different in the same naphthalene ring or benzene ring.

Each R^{4A} is independently a dissociation group, a crosslinkable group or a hydrogen atom; and
each m^{6A} is independently an integer of 0 to 5.

In addition, the compound represented by the above formula (1-2-1) is preferably a compound represented by the following formula (2a) from the viewpoint of the supply of raw materials.

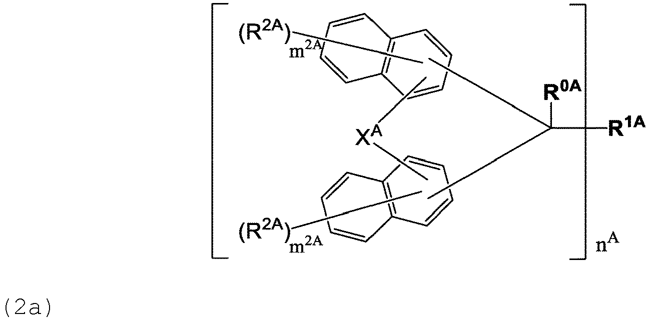

In the above formula (2a), each R^{2A} is independently a linear, branched or cyclic alkyl group having 1 to 30 carbon atoms and optionally having a substituent, an aryl group having 6 to 30 carbon atoms and optionally having a substituent, an alkenyl group having 2 to 30 carbon atoms and optionally having a substituent, an alkynyl group having 2 to 30 carbon atoms and optionally having a substituent, an alkoxy group having 1 to 30 carbon atoms and optionally having a substituent, a halogen atom, a nitro group, an amino group, a carboxylic acid group, a crosslinkable group, a dissociation group, a thiol group, a hydroxy group or a group containing a group in which a hydrogen atom of a hydroxy group is replaced with an alkynyl group having 2 to 30 carbon atoms, wherein the alkyl group, the aryl group, the alkenyl group, the alkynyl group and the alkoxy group each optionally contain an ether bond, a ketone bond or an ester bond and where at least one R^{2A} contains a crosslinkable group, a dissociation group or a hydroxy group.

Each m^{2A} is independently an integer of 0 to 7. However, at least one m^{2A} is an integer of 1 to 7.

X^{A}, R^{0A} to R^{1A} and n^{A} are as defined in the description of the above formula (1-2-1).

Also, the compound represented by the above formula (1-2-1) is more preferably a compound represented by the following formula (2b) from the viewpoint of solubility in an organic solvent.

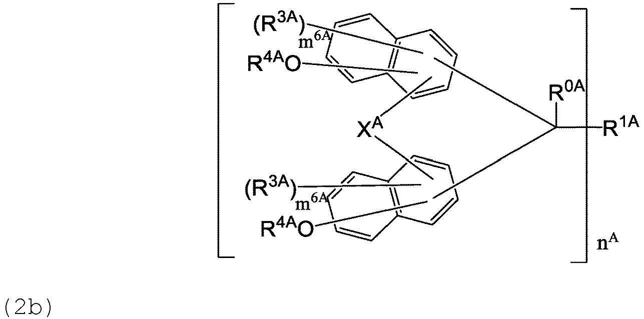

In the above formula (2b), X^{A}, R^{0A}, R^{1A}, R^{3A}, R^{4A}, m^{6A} and n^{A} are as defined in the description of the above formula (1-2-1).

In addition, the compound represented by the above formula (1-2-1) is further preferably a compound represented by the following formula (2c) from the viewpoint of solubility in an organic solvent.

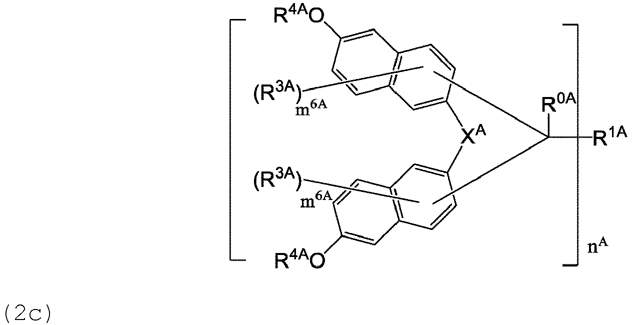

In the above formula (2c), X^{A}, R^{0A}, R^{1A}, R^{3A}, R^{4A}, m^{6A} and n^{A} are as defined in the description of the above formula (1-2-1).

Examples of the compound represented by the above formula (1) will be listed below, but are not limited thereto. For example, compounds described in International Publication No. WO 2013/024778, International Publication No. WO 2015/137486, International Publication No. WO 2016/158458, International Publication No. WO 2017/038643, International Publication No. WO 2017/038645, International Publication No. WO 2017/038979, International Publication No. WO 2017/043561, International Publication No. WO 2017/111165, International Publication No. WO 2017/135498, International Publication No. WO 2017/155495, and Japanese Patent Laid-Open No. 2018-15460 can also be used.

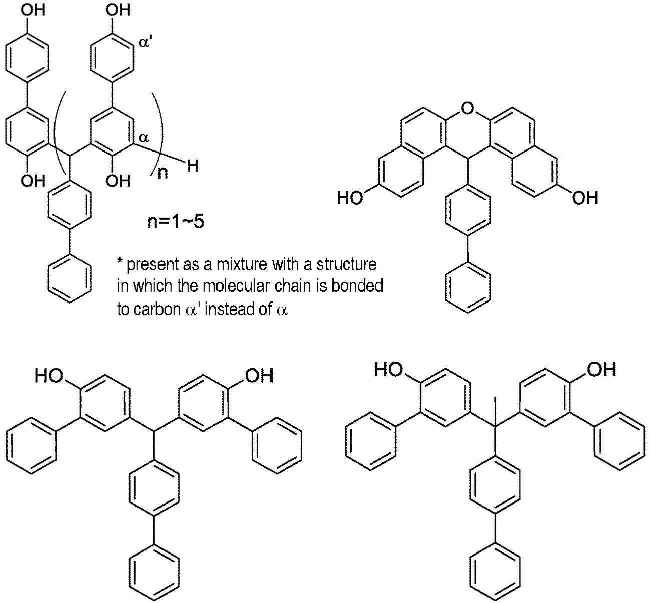

Also, the compound represented by the above formula (1-2-1) is more preferably a compound represented by the following formula (3) from the viewpoint that high solubility, high sensitivity and high etching resistance are all achieved. 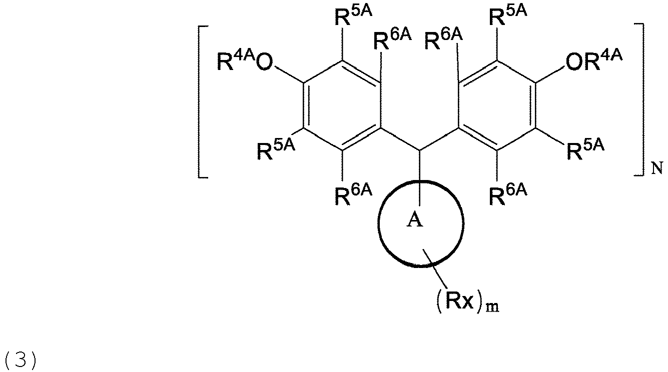 (In the formula (3), A is an N-valent group having 1 to 60 carbon atoms and optionally having a substituent, and each Rx is independently an alkyl group having 1 to 30 carbon atoms and optionally having a substituent, an aryl group having 6 to 30 carbon atoms and optionally having a substituent, an alkenyl group having 2 to 30 carbon atoms and optionally having a substituent, an alkynyl group optionally having a substituent, an alkoxy group having 1 to 30 carbon atoms and optionally having a substituent, a halogen atom, a nitro group, an amino group, a carboxylic acid group, a crosslinkable group, a dissociation group, a thiol group, or a hydroxy group (provided that at least one Rx contains iodine); each R^{4A} is independently a dissociation group, a crosslinkable group or a hydrogen atom, each R^{5A} is independently an alkyl group having 1 to 30 carbon atoms and optionally having a substituent, an aryl group having 6 to 30 carbon atoms and optionally having a substituent, an alkenyl group having 2 to 30 carbon atoms and optionally having a substituent, an alkynyl group optionally having a substituent, an alkoxy group having 1 to 30 carbon atoms and optionally having a substituent, a halogen atom, a nitro group, an amino group, a carboxylic acid group, a crosslinkable group, a dissociation group, a thiol group, or a hydroxy group, and each R^{6A} is independently a hydrogen atom, an alkyl group having 1 to 30 carbon atoms and optionally having a substituent, an aryl group having 6 to 30 carbon atoms and optionally having a substituent, an alkenyl group having 2 to 30 carbon atoms and optionally having a substituent, an alkynyl group optionally having a substituent, an alkoxy group having 1 to 30 carbon atoms and optionally having a substituent, a halogen atom, a nitro group, an amino group, a carboxylic acid group, a crosslinkable group, a dissociation group, a thiol group, or a hydroxy group;
each m is independently an integer of 1 to 20; and N is as defined in the description of the above formula (1).)

Also, the compound represented by the above formula (3) is more preferably a compound represented by the following formula (3-1) from the viewpoint of providing further higher solubility. 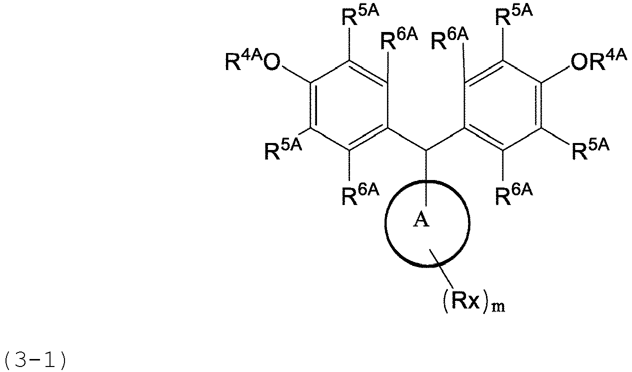 (In the above formula (3-1), A, Rx, R^{5A}, R^{6A}, m and R^{4A} are as defined in the description of the above formula (3).)

In addition, the compound represented by the above formula (3-1) is more preferably a compound represented by the following formula (3-2) from the viewpoint of providing further higher solubility. 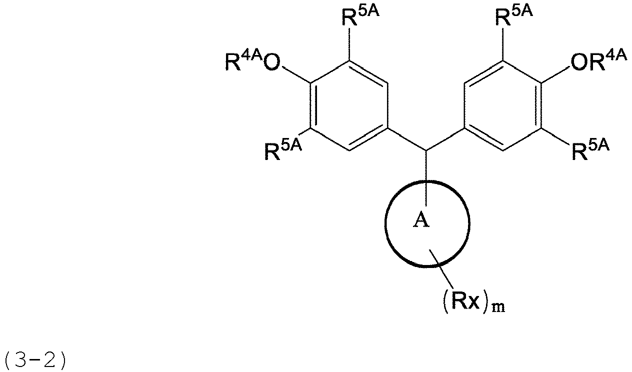 (In the above formula (3-2), A, Rx, R^{4A}, R^{5A} and m are as defined in the description of the above formula (3-1).)

In addition, the compound represented by the above formula (3) is preferably a compound represented by the following formula (3-0) from the viewpoint of the availability of raw materials. 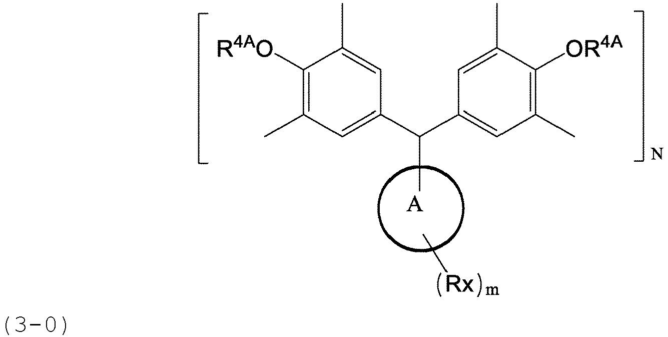 (In the above formula (3-0), A, Rx, m, R^{4A} and N are as defined in the description of the above formula (3).)

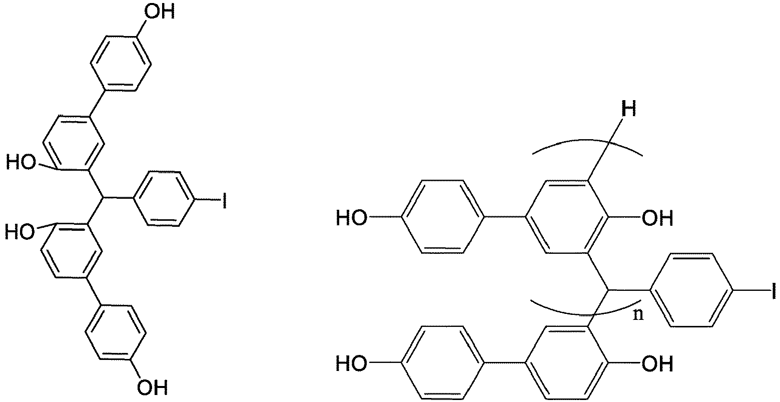

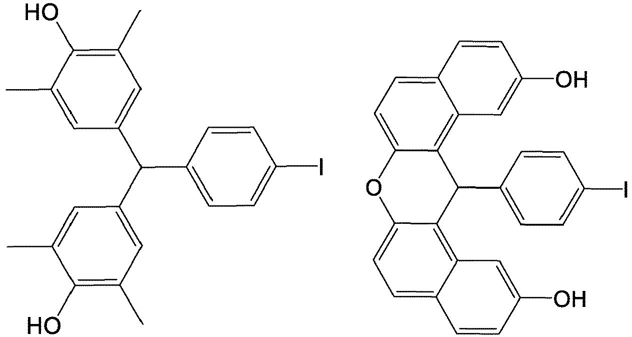

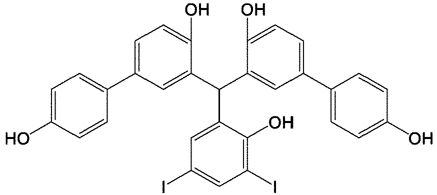

### (Resin having structure represented by formula (2))

A resin obtained with the compound represented by the above formula (1) as a monomer can be used as a composition. Such a resin can be obtained, for example, by reacting the compound represented by the above formula (1) with a crosslinking compound.

Examples of the resin obtained with the compound represented by the above formula (1) as a monomer include a resin represented by the following formula (2). That is, the composition of the present embodiment may contain a resin having a structure represented by the following formula (2). 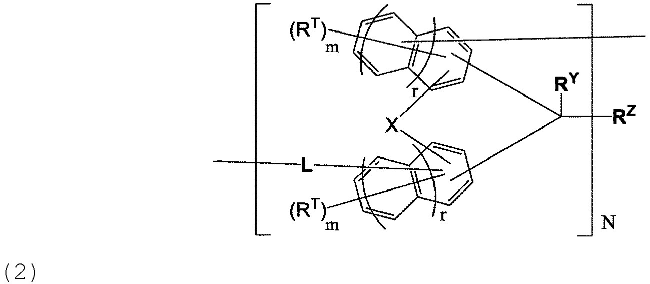 (In the formula (2), L is an alkylene group having 1 to 30 carbon atoms and optionally having a substituent, an arylene group having 6 to 30 carbon atoms and optionally having a substituent, an alkoxylene group having 1 to 30 carbon atoms and optionally having a substituent, or a single bond, wherein the alkylene group, the arylene group and the alkoxylene group each optionally contain an ether bond, a ketone bond or an ester bond;
R^{Y} is a hydrogen atom, an alkyl group having 1 to 30 carbon atoms or an aryl group having 6 to 30 carbon atoms;
R^{Z} is an N-valent group having 1 to 60 carbon atoms or a single bond;
each R^{T} is independently an alkyl group having 1 to 30 carbon atoms and optionally having a substituent, an aryl group having 6 to 30 carbon atoms and optionally having a substituent, an alkenyl group having 2 to 30 carbon atoms and optionally having a substituent, an alkynyl group having 2 to 30 carbon atoms and optionally having a substituent, an alkoxy group having 1 to 30 carbon atoms and optionally having a substituent, a halogen atom, a nitro group, an amino group, a carboxylic acid group, an acid crosslinkable group, an acid dissociation group, a thiol group, or a hydroxy group (provided that at least one R^{T} contains a crosslinkable group, a dissociation group or a hydroxy group), wherein the alkyl group, the aryl group, the alkenyl group, the alkynyl group and the alkoxy group each optionally contain an ether bond, a ketone bond or an ester bond;
X is an oxygen atom, a sulfur atom or not a crosslink;
each m is independently an integer of 0 to 9 (provided that at least one m is an integer of 1 to 9);
N is an integer of 1 to 4 (provided that when N is an integer of 2 or larger, N structural formulas within the parentheses [ ] are the same or different); and
each r is independently an integer of 0 to 2.)

In the formula (2), L is an alkylene group having 1 to 30 carbon atoms and optionally having a substituent, an arylene group having 6 to 30 carbon atoms and optionally having a substituent, an alkoxylene group having 1 to 30 carbon atoms and optionally having a substituent, or a single bond, and the alkylene group, the arylene group and the alkoxylene group each optionally contain an ether bond, a ketone bond or an ester bond. Each of the alkylene group and the alkoxylene group may be a linear, branched or cyclic group.

R^{Z}, R^{Y}, R^{Y}, m, r and N are as defined in the above formula (1).

In the present embodiment, the weight average molecular weight of the resin having a structure represented by the formula (2) is preferably 300 to 10000, still more preferably 300 to 5000, and particularly preferably 300 to 3000 from the viewpoints of reducing defects in a film to be formed by using the composition and of a good pattern shape. As the above weight average molecular weight, a value obtained by measuring the weight average molecular weight in terms of polystyrene, using GPC, can be used.

### - Method for producing resin having structure represented by formula (2) -

The resin having a structure represented by the formula (2) is obtained by reacting the compound represented by the above formula (1) with a crosslinking compound. As the crosslinking compound, a publicly known compound can be used without particular limitations as long as it can oligomerize or polymerize the compound represented by the above formula (1). Specific examples of the crosslinking compound include, but not particularly limited to, an aldehyde, a ketone, a carboxylic acid, a carboxylic acid halide, a halogen containing compound, an amino compound, an imino compound, an isocyanate, and an unsaturated hydrocarbon group containing compound.

Specific examples of the resin having a structure represented by the above formula (2) include a resin that is made novolac through, for example, a condensation reaction between the compound represented by the above formula (1) with an aldehyde and/or a ketone, which is a crosslinking compound.

The resin having a structure represented by the formula (2) can also be obtained upon the synthesis reaction for the compound represented by the above formula (1). For example, upon synthesizing the compound represented by the above formula (1), there are some cases that the compound represented by the above formula (1) is subjected to condensation reaction with an aldehyde or a ketone and the resin having a structure represented by the formula (2) is obtained.

### [Solvent (S)]

As a solvent according to the present embodiment, a publicly known solvent can be arbitrarily used as long as it can at least dissolve the base material (A) and the polyphenol compound (B) mentioned above. Specific examples of the solvent can include, but not particularly limited to, an ethylene glycol monoalkyl ether acetate such as ethylene glycol monomethyl ether acetate, ethylene glycol monoethyl ether acetate, ethylene glycol mono-n-propyl ether acetate, and ethylene glycol mono-n-butyl ether acetate; an ethylene glycol monoalkyl ether such as ethylene glycol monomethyl ether and ethylene glycol monoethyl ether; a propylene glycol monoalkyl ether acetate such as propylene glycol monomethyl ether acetate (PGMEA), propylene glycol monoethyl ether acetate, propylene glycol mono-n-propyl ether acetate, and propylene glycol mono-n-butyl ether acetate; a propylene glycol monoalkyl ethers such as propylene glycol monomethyl ether (PGME) and propylene glycol monoethyl ether; a lactate ester such as methyl lactate, ethyl lactate, n-propyl lactate, n-butyl lactate, and n-amyl lactate; an aliphatic carboxylic acid ester such as methyl acetate, ethyl acetate, n-propyl acetate, n-butyl acetate, n-amyl acetate, n-hexyl acetate, methyl propionate, and ethyl propionate; another ester such as methyl 3-methoxypropionate, ethyl 3-methoxypropionate, methyl 3-ethoxypropionate, ethyl 3-ethoxypropionate, methyl 3-methoxy-2-methylpropionate, 3-methoxybutyl acetate, 3-methyl-3-methoxybutyl acetate, butyl 3-methoxy-3-methylpropionate, butyl 3-methoxy-3-methylbutyrate, methyl acetoacetate, methyl pyruvate, and ethyl pyruvate; an aromatic hydrocarbon such as toluene and xylene; a ketone such as acetone, 2-butanone, 2-heptanone, 3-heptanone, 4-heptanone, cyclopentanone (CPN), and cyclohexanone (CHN); an amide such as N,N-dimethylformamide, N-methylacetamide, N,N-dimethylacetamide, and N-methylpyrrolidone; and a lactone such as γ-lactone. The solvent used in the present embodiment is preferably a safe solvent, more preferably at least one selected from PGMEA, PGME, CHN, CPN, 2-heptanone, anisole, butyl acetate and ethyl lactate, and still more preferably at least one selected from PGMEA, PGME, CHN, CPN and ethyl lactate.

In the present embodiment, the amount of the solid component and the amount of the solvent are not particularly limited, but preferably the solid component is 1 to 80% by mass and the solvent is 20 to 99% by mass, more preferably the solid component is 1 to 50% by mass and the solvent is 50 to 99% by mass, still more preferably the solid component is 2 to 40% by mass and the solvent is 60 to 98% by mass, and particularly preferably the solid component is 2 to 10% by mass and the solvent is 90 to 98% by mass, based on the total mass of the amount of the solid component and the solvent.

### [Acid generating agent (C)]

The composition of the present embodiment preferably contains one or more acid generating agents (C) generating an acid directly or indirectly by irradiation of any radiation selected from visible light, ultraviolet, excimer laser, electron beam, extreme ultraviolet (EUV), X-ray and ion beam. The acid generating agent (C) is not particularly limited, and, for example, an acid generating agent described in International Publication No. WO 2013/024778 can be used. The acid generating agent (C) can be used alone or in combination of two or more kinds.

The amount of the acid generating agent (C) used is preferably 0.001 to 49% by mass of the total mass of the solid component, more preferably 1 to 40% by mass, still more preferably 3 to 30% by mass, and particularly preferably 10 to 25% by mass. By using the acid generating agent (C) within the above range, a pattern profile with high sensitivity and low edge roughness is obtained. In the present embodiment, the acid generation method is not limited as long as an acid is generated in the system. By using excimer laser instead of ultraviolet such as g-ray and i-ray, finer processing is possible, and also by using electron beam, extreme ultraviolet, X-ray or ion beam as a high energy ray, further finer processing is possible.

### [Crosslinking agent (G)]

In the present embodiment, one or more crosslinking agents (G) can be contained in the composition. The crosslinking agent (G) refers to a compound that can at least crosslink either base material (A) or polyphenol compound (B). It is preferable that the above crosslinking agent (G) be an acid crosslinking agent capable of intramolecularly or intermolecularly crosslinking the base material (A) in the presence of the acid generated from the acid generating agent (C). Examples of such an acid crosslinking agent can include a compound having one or more groups capable of crosslinking the base material (A) (hereinafter, referred to as a "crosslinkable group").

Examples of the above crosslinkable group can include: (i) a hydroxyalkyl group or a group derived therefrom, such as a hydroxy (alkyl group having 1 to 6 carbon atoms), alkoxy having 1 to 6 carbon atoms (alkyl group having 1 to 6 carbon atoms) and acetoxy (alkyl group having 1 to 6 carbon atoms); (ii) a carbonyl group or a group derived therefrom, such as a formyl group and a carboxy (alkyl group having 1 to 6 carbon atoms); (iii) a nitrogenous group containing group such as a dimethylaminomethyl group, a diethylaminomethyl group, a dimethylolaminomethyl group, a diethylolaminomethyl group and a morpholinomethyl group; (iv) a glycidyl group containing group such as a glycidyl ether group, a glycidyl ester group and a glycidylamino group; (v) a group derived from an aromatic group such as an allyloxy having 1 to 6 carbon atoms (alkyl group having 1 to 6 carbon atoms) and an aralkyloxy having 1 to 6 carbon atoms (alkyl group having 1 to 6 carbon atoms) such as a benzyloxymethyl group and a benzoyloxymethyl group; and (vi) a polymerizable multiple bond containing group such as a vinyl group and an isopropenyl group. As the crosslinkable group of the crosslinking agent (G) according to the present embodiment, a hydroxyalkyl group, an alkoxyalkyl group and the like are preferable, and an alkoxymethyl group is particularly preferable.

The crosslinking agent (G) having the above crosslinkable group is not particularly limited, and, for example, an acid crosslinking agent described in International Publication No. WO 2013/024778 can be used. The crosslinking agent (G) can be used alone or in combination of two or more kinds.

In the present embodiment, the amount of the crosslinking agent (G) used is preferably 0.5 to 49% by mass of the total mass of the solid component, more preferably 0.5 to 40% by mass, still more preferably 1 to 30% by mass, and particularly preferably 2 to 20% by mass. When the content ratio of the above crosslinking agent (G) is 0.5% by mass or more, the inhibiting effect of the solubility of a resist film in an alkaline developing solution is improved, and a decrease in the film remaining rate, and occurrence of swelling and meandering of a pattern can be inhibited, which is preferable. On the other hand, when the content is 50% by mass or less, a decrease in heat resistance as a resist can be inhibited, which is preferable.

### [Acid diffusion controlling agent (E)]

In the present embodiment, the composition of the present embodiment may contain an acid diffusion controlling agent (E) having a function of controlling diffusion of an acid generated from an acid generating agent by radiation irradiation in a resist film to inhibit any unpreferable chemical reaction in an unexposed region or the like. By using the acid diffusion controlling agent (E), the storage stability of the composition of the present embodiment can be improved. Also, by using the acid diffusion controlling agent (E), not only the resolution of a film formed by using the composition of the present embodiment can be improved, but the line width change of a resist pattern due to variation in the post exposure delay time before radiation irradiation and the post exposure delay time after radiation irradiation can also be inhibited, making the composition extremely excellent in process stability. Examples of the acid diffusion controlling agent (E) include, but not particularly limited to, a radiation degradable basic compound such as a nitrogen atom containing basic compound, a basic sulfonium compound, and a basic iodonium compound.

The acid diffusion controlling agent (E) is not particularly limited, and, for example, an acid diffusion controlling agent described in International Publication No. WO 2013/024778 can be used. The acid diffusion controlling agent (E) can be used alone or in combination of two or more kinds.

The content of the acid diffusion controlling agent (E) is preferably 0.001 to 49% by mass of the total mass of the solid component, more preferably 0.01 to 10% by mass, still more preferably 0.01 to 5% by mass, and particularly preferably 0.01 to 3% by mass. Within the above range, a decrease in resolution, and deterioration of the pattern shape and the dimension fidelity or the like can be prevented. Moreover, even though the post exposure delay time from electron beam irradiation to heating after radiation irradiation becomes longer, the shape of the pattern upper layer portion does not deteriorate. When the content is 10% by mass or less, a decrease in sensitivity, and developability of the unexposed portion or the like can be prevented. Also, by using such an acid diffusion controlling agent, the storage stability of a resist composition is improved, also along with improvement of the resolution, the line width change of a resist pattern due to variation in the post exposure delay time before radiation irradiation and the post exposure delay time after radiation irradiation can be inhibited, making the composition extremely excellent in process stability.

### [Further component (F)]

To the composition of the present embodiment, if required, as the further component (F), one kind or two kinds or more of various additive agents such as a dissolution promoting agent, a dissolution controlling agent, a sensitizing agent, a surfactant, and an organic carboxylic acid or an oxo acid of phosphor or derivative thereof can be added.

### (Dissolution promoting agent)

The dissolution promoting agent is a component having a function of, when the solubility of a solid component is too low, increasing the solubility of the solid component in a developing solution to moderately increase the dissolution rate of that compound upon developing. As the above dissolution promoting agent, those having a low molecular weight are preferable, and examples thereof can include a phenolic compound having a low molecular weight. Examples of the phenolic compound having a low molecular weight can include a bisphenol and a tris(hydroxyphenyl)methane. These dissolution promoting agents can be used alone or in mixture of two or more kinds.

The content of the dissolution promoting agent, which is arbitrarily adjusted according to the kind of the above solid component to be used, is preferably 0 to 49% by mass of the total mass of the solid component, more preferably 0 to 5% by mass, still more preferably 0 to 1% by mass, and particularly preferably 0% by mass.

### (Dissolution controlling agent)

The dissolution controlling agent is a component having a function of, when the solubility of a solid component is too high, controlling the solubility of the solid component in a developing solution to moderately decrease the dissolution rate upon developing. As such a dissolution controlling agent, the one which does not chemically change in steps such as calcination of resist coating, radiation irradiation, and development is preferable.

The dissolution controlling agent is not particularly limited, and examples can include aromatic hydrocarbons such as phenanthrene, anthracene, and acenaphthene; ketones such as acetophenone, benzophenone, and phenyl naphthyl ketone; and sulfones such as methyl phenyl sulfone, diphenyl sulfone, and dinaphthyl sulfone. These dissolution controlling agents can be used alone or in combination of two or more kinds.

The content of the dissolution controlling agent, which is arbitrarily adjusted according to the kind of the above compound to be used, is preferably 0 to 49% by mass of the total mass of the solid component, more preferably 0 to 5% by mass, still more preferably 0 to 1% by mass, and particularly preferably 0% by mass.

### (Sensitizing agent)

The sensitizing agent is a component having a function of absorbing irradiated radiation energy, transmitting the energy to the acid generating agent (C), and thereby increasing the acid production amount, and improving the apparent sensitivity of a resist. Such a sensitizing agent is not particularly limited, and examples thereof can include benzophenones, biacetyls, pyrenes, phenothiazines, and fluorenes. These sensitizing agents can be used alone or in combination of two or more kinds.

The content of the sensitizing agent, which is arbitrarily adjusted according to the kind of the above compound to be used, is preferably 0 to 49% by mass of the total mass of the solid component, more preferably 0 to 5% by mass, still more preferably 0 to 1% by mass, and particularly preferably 0% by mass.

### (Surfactant)

The surfactant is a component having a function of improving coatability and striation of the composition of the present embodiment, and developability of a resist or the like. The surfactant may be any of anionic, cationic, nonionic, and amphoteric surfactants. Preferable examples of the surfactant include a nonionic surfactant. The nonionic surfactant has a good affinity with a solvent to be used in production of the composition of the present embodiment, and can further enhance the effects of the composition of the present embodiment. Examples of the nonionic surfactant include, but not particularly limited to, a polyoxyethylene higher alkyl ether, a polyoxyethylene higher alkyl phenyl ether, and a higher fatty acid diester of polyethylene glycol. Examples of commercially available products of these surfactants can include, hereinafter by trade name, EFTOP (manufactured by Jemco Inc.), MEGAFAC (manufactured by DIC Corporation), Fluorad (manufactured by Sumitomo 3M Limited), AsahiGuard, Surflon (hereinbefore, manufactured by Asahi Glass Co., Ltd.), Pepole (manufactured by Toho Chemical Industry Co., Ltd.), KP (manufactured by Shin-Etsu Chemical Co., Ltd.), and Polyflow (manufactured by Kyoeisha Chemical Co., Ltd.).

The content of the surfactant, which is arbitrarily adjusted according to the kind of the above solid component to be used, is preferably 0 to 49% by mass of the total mass of the solid component, more preferably 0 to 5% by mass, still more preferably 0 to 1% by mass, and particularly preferably 0% by mass.

### (Organic carboxylic acid or oxo acid of phosphor or derivative thereof)

For the purpose of prevention of sensitivity deterioration or improvement of a resist pattern shape and post exposure delay stability or the like, and as an additional optional component, the composition of the present embodiment can contain an organic carboxylic acid or an oxo acid of phosphor or derivative thereof. The organic carboxylic acid or the oxo acid of phosphor or derivative thereof can be used in combination with the acid diffusion controlling agent, or may be used alone. As the organic carboxylic acid, for example, malonic acid, citric acid, malic acid, succinic acid, benzoic acid, salicylic acid and the like are preferable. Examples of the oxo acid of phosphor or derivative thereof include phosphoric acid or derivative thereof such as ester including phosphoric acid, di-n-butyl phosphate and diphenyl phosphate; phosphonic acid or derivative thereof such as ester including phosphonic acid, dimethyl phosphonate, di-n-butyl phosphonate, phenylphosphonic acid, diphenyl phosphonate and dibenzyl phosphonate; and phosphinic acid and derivative thereof such as ester including phosphinic acid and phenylphosphinic acid. Among them, phosphonic acid is particularly preferable.

The organic carboxylic acid or the oxo acid of phosphor or derivative thereof can be used alone or in combination of two or more kinds. The content of the organic carboxylic acid or the oxo acid of phosphor or derivative thereof, which is arbitrarily adjusted according to the kind of the above compound to be used, is preferably 0 to 49% by mass of the total mass of the solid component, more preferably 0 to 5% by mass, still more preferably 0 to 1% by mass, and particularly preferably 0% by mass.

### [Further additive agent]

Furthermore, the composition of the present embodiment can contain one kind or two kinds or more of additive agents other than the components mentioned above, if required. Examples of such an additive agent include a dye, a pigment and an adhesion aid. For example, when the composition contains a dye or a pigment, a latent image of the exposed portion is visualized and influence of halation upon exposure can be alleviated, which is preferable. Also, when the composition contains an adhesion aid, adhesiveness to a substrate can be improved, which is preferable. Furthermore, examples of the further additive agent can include a halation preventing agent, a storage stabilizing agent, a defoaming agent and a shape improving agent. Specific examples thereof can include 4-hydroxy-4'-methylchalkone.

In the composition of the present embodiment, the total content of the optional component (F) can be 0 to 99% by mass of the total mass of the solid component, and is preferably 0 to 49% by mass, more preferably 0 to 10% by mass, still more preferably 0 to 5% by mass, further preferably 0 to 1% by mass, and particularly preferably 0% by mass.

### [Content ratio of each component in composition]

In the composition of the present embodiment, the total amount of the base material (A) and the polyphenol compound (B) is not particularly limited as long as the mass ratio between the base material (A) and the polyphenol compound (B) is 5:95 to 95:5, but is preferably 50 to 99.4% by mass of the total mass of the solid component (summation of solid components including the base material (A), the polyphenol compound (B), and optionally used components such as acid generating agent (C), crosslinking agent (G), acid diffusion controlling agent (E), and further component (F), hereinafter the same), more preferably 55 to 90% by mass, still more preferably 60 to 80% by mass, and particularly preferably 60 to 70% by mass. In the case of the above content, resolution is further improved, and line edge roughness (LER) is further decreased. When the composition contains both the compound and the resin according to the present embodiment, the above content refers to an amount including both the compound and the resin according to the present embodiment.

In the composition of the present embodiment, the content ratio among the base material (A), the polyphenol compound (B), the acid generating agent (C), the crosslinking agent (G), the acid diffusion controlling agent (E) and an optional component (F) according to the present embodiment (base material (A)/polyphenol compound (B)/acid generating agent (C)/crosslinking agent (G)/acid diffusion controlling agent (E)/optional component (F)) is, based on the total mass of the solid component of the composition of the present embodiment,
preferably, 5.2 to 94.7% by mass/5.2 to 94.7% by mass/0.001 to 49% by mass/0.5 to 49% by mass/0.001 to 49% by mass/0 to 49% by mass;
more preferably, 20.1 to 93.7% by mass/5.2 to 79.9% by mass/1 to 40% by mass/0.5 to 40% by mass/0.01 to 10% by mass/0 to 5% by mass;
still more preferably, 50.1 to 90.7% by mass/5.2 to 45.8% by mass/3 to 30% by mass/1 to 30% by mass/0.01 to 5% by mass/0 to 1% by mass; and
particularly preferably, 71.0 to 90.7 parts by mass/5.2 to 25.0 parts by mass/3 to 30 parts by mass/1 to 30% by mass/0.01 to 3% by mass/0 parts by mass.

The content ratio of each component is selected from each range so that the summation thereof is 100% by mass. By the above content ratio, performance such as sensitivity, resolution, and developability is excellent. A "solid component" refers to a component except for the solvent. The "total mass of the solid component" means that the total of components excluding the solvent from the components constituting the composition is 100% by mass.

The composition of the present embodiment is normally prepared by dissolving each component in a solvent upon use into a homogeneous solution, and then if required, filtering through a filter or the like with a pore diameter of about 0.2 µm, for example.

### [Physical properties and the like of composition]

The composition of the present embodiment can form an amorphous film by spin coating. Also, the composition of the present embodiment can be applied to a general semiconductor production process. In addition, any of positive type and negative type resist patterns can be individually prepared from the composition of the present embodiment, depending on the kind of a developing solution to be used.

In the case of a positive type resist pattern, the dissolution rate of an amorphous film formed by spin coating with the composition of the present embodiment in a developing solution at 23°C is preferably 5 angstrom/sec or less, more preferably 0.05 to 5 angstrom/sec, and still more preferably 0.0005 to 5 angstrom/sec. When the dissolution rate is 5 angstrom/sec or less, the amorphous film can be made into a resist that is insoluble in the developing solution. In addition, when the amorphous film has a dissolution rate of 0.0005 angstrom/sec or more, the resolution may be improved. It is presumed that this is because due to the change in the solubility before and after exposure of the base material (A), contrast at the interface between the exposed portion being dissolved in the developing solution and the unexposed portion not being dissolved in the developing solution is increased. Also, when the amorphous film has a dissolution rate of 0.0005 angstrom/sec or more, there are effects of reducing LER and defects.

In the case of a negative type resist pattern, the dissolution rate of an amorphous film formed by spin coating with the composition of the present embodiment in a developing solution at 23°C is preferably 10 angstrom/sec or more. When the dissolution rate is 10 angstrom/sec or more, the amorphous film is easily dissolved in a developing solution, and is more suitable for a resist. In addition, when the amorphous film has a dissolution rate of 10 angstrom/sec or more, the resolution may be improved. It is presumed that this is because the micro surface portion of the base material (A) is dissolved, and LER is reduced. Also, when the amorphous film has a dissolution rate of 10 angstrom/sec or more, there is an effect of reducing defects.

The above dissolution rate can be determined by immersing the amorphous film in a developing solution for a predetermined period of time at 23°C and then measuring the film thickness before and after the immersion by a publicly known method such as visual, ellipsometric or QCM method.

In the case of a positive type resist pattern, the dissolution rate of a portion, exposed by radiation such as KrF excimer laser, extreme ultraviolet, electron beam or X-ray, of the amorphous film formed by spin coating with the composition of the present embodiment in a developing solution at 23°C is preferably 10 angstrom/sec or more. When the dissolution rate is 10 angstrom/sec or more, the amorphous film is easily dissolved in a developing solution, and is more suitable for a resist. In addition, when the amorphous film has a dissolution rate of 10 angstrom/sec or more, the resolution may be improved. It is presumed that this is because the micro surface portion of the base material (A) is dissolved, and LER is reduced. Also, when the dissolution rate is 10 angstrom/sec or more, there is an effect of reducing defects.

In the case of a negative type resist pattern, the dissolution rate of a portion, exposed by radiation such as KrF excimer laser, extreme ultraviolet, electron beam or X-ray, of the amorphous film formed by spin coating with the composition of the present embodiment, in a developing solution at 23°C is preferably 5 angstrom/sec or less, more preferably 0.05 to 5 angstrom/sec, and still more preferably 0.0005 to 5 angstrom/sec. When the dissolution rate is 5 angstrom/sec or less, the amorphous film can be made into a resist that is insoluble in the developing solution. In addition, when the amorphous film has a dissolution rate of 0.0005 angstrom/sec or more, the resolution may be improved. It is presumed that this is because due to the change in the solubility before and after exposure of the base material (A), contrast at the interface between the unexposed portion being dissolved in the developing solution and the exposed portion not being dissolved in the developing solution is increased. Also, when the amorphous film has a dissolution rate of 0.0005 angstrom/sec or more, there are effects of reducing LER and defects.

### [Method for producing amorphous film]

The composition of the present embodiment can be used to form an amorphous film on a substrate.

### [Resist pattern formation method using composition]

A method for forming a resist pattern, using the composition of the present embodiment, comprises the steps of: forming a photoresist layer on a substrate, using the radiation-sensitive composition; irradiating a predetermined region of the photoresist layer formed on the substrate with radiation; and developing the photoresist layer after the radiation irradiation.

A method for forming a resist pattern, using the composition of the present embodiment, comprises the steps of: forming a resist film on a substrate, using the composition of the present embodiment mentioned above; exposing at least a portion of the formed resist film; and developing the exposed resist film, thereby forming a resist pattern. The resist pattern according to the present embodiment can also be formed as an upper layer resist in a multilayer process.

Examples of the resist pattern formation method include, but not particularly limited to, the following method. A resist film (photoresist layer) is formed by coating a conventionally publicly known substrate with the composition of the present embodiment using a coating means such as spin coating, flow casting coating and roll coating. Examples of the conventionally publicly known substrate can include, but not particularly limited to, a substrate for electronic components, and the one having a predetermined wiring pattern formed thereon, or the like. More specific examples thereof include a silicon wafer, a substrate made of a metal such as copper, chromium, iron and aluminum, and a glass substrate. Examples of the wiring pattern material include copper, aluminum, nickel and gold. Also, if required, the substrate mentioned above may have an inorganic and/or organic film provided thereon. Examples of the inorganic film include an inorganic antireflection film (inorganic BARC). Examples of the organic film include an organic antireflection film (organic BARC). A surface treatment with hexamethylene disilazane or the like may be carried out.

Next, the coated substrate is heated, if required. The heating conditions vary according to the compounding composition of the composition or the like, but are preferably 20 to 250°C, and more preferably 20 to 150°C. By heating, the adhesiveness of the composition to the substrate may be improved, which is preferable. Then, the resist film is exposed to a desired pattern by any radiation selected from the group consisting of visible light, ultraviolet, excimer laser, electron beam, extreme ultraviolet (EUV), X-ray and ion beam. The exposure conditions or the like are arbitrarily selected according to the compounding composition of the composition or the like. In the present embodiment, in order to stably form a fine pattern with a high degree of accuracy in exposure, the resist film is preferably heated after radiation irradiation.

Next, by developing the exposed resist film in a developing solution, a predetermined resist pattern is formed. As the above developing solution, it is preferable to select a solvent having a solubility parameter (SP value) close to that of the base material (A) to be used. For example, a polar solvent such as a ketone-based solvent, an ester-based solvent, an alcohol-based solvent, an amide-based solvent and an ether-based solvent described in International Publication No. WO 2013/24778; and a hydrocarbon-based solvent, or an alkaline aqueous solution can be used.

A plurality of above solvents may be mixed, or the solvent may be used by mixing the solvent with a solvent other than those described above or water within the range having performance. However, in order to sufficiently exhibit the effect of the present embodiment, the water content ratio as the whole developing solution is less than 70% by mass, and is preferably less than 50% by mass, more preferably less than 30% by mass, and still more preferably less than 10% by mass. Particularly preferably, the developing solution is substantially moisture free. That is, the content of the organic solvent in the developing solution is preferably 30% by mass or more and 100% by mass or less based on the total amount of the developing solution, preferably 50% by mass or more and 100% by mass or less, more preferably 70% by mass or more and 100% by mass or less, still more preferably 90% by mass or more and 100% by mass or less, and particularly preferably 95% by mass or more and 100% by mass or less.

Particularly, the developing solution containing at least one kind of solvent selected from a ketone-based solvent, an ester-based solvent, an alcohol-based solvent, an amide-based solvent and an ether-based solvent improves resist performance such as resolution and roughness of the resist pattern, which is thus preferable.

The vapor pressure of the developing solution is preferably 5 kPa or less at 20°C, more preferably 3 kPa or less, and particularly preferably 2 kPa or less. By setting the vapor pressure of the developing solution to 5 kPa or less, the evaporation of the developing solution on the substrate or in a developing cup is inhibited, temperature uniformity within the wafer surface is improved, and size uniformity within the wafer surface is improved consequently.

Specific examples of the developing solution having a vapor pressure of 5 kPa or less include those described in International Publication NO. WO 2013/24778.

Specific examples of the developing solution having a vapor pressure of 2 kPa or less, which is a particularly preferable range, include those described in International Publication NO. WO 2013/24778.

To the developing solution, a surfactant can be added in an appropriate amount, if required. The surfactant is not particularly limited, but, for example, an ionic or nonionic fluorine-based and/or silicon-based surfactant can be used. Examples of the fluorine-based and/or silicon-based surfactant can include the surfactants described in Japanese Patent Laid-Open Nos. 62-36663, 61-226746, 61-226745, 62-170950, 63-34540, 7-230165, 8-62834, 9-54432, and 9-5988, and U.S. Pat. Nos. 5,405,720, 5,360,692, 5,529,881, 5,296,330, 5,436,098, 5,576,143, 5,294,511, and 5,824,451. The surfactant is preferably a nonionic surfactant. The nonionic surfactant is not particularly limited, but it is still more preferable to use a fluorine-based surfactant or a silicon-based surfactant.

The amount of the surfactant used is normally 0.001 to 5% by mass based on the total amount of the developing solution, preferably 0.005 to 2% by mass, and still more preferably 0.01 to 0.5% by mass.

For the development method, for example, a method for dipping a substrate in a bath filled with a developing solution for a fixed time (dipping method), a method for raising a developing solution on a substrate surface by the effect of a surface tension and keeping it still for a fixed time, thereby conducting the development (puddle method), a method for spraying a developing solution on a substrate surface (spraying method), and a method for continuously ejecting a developing solution on a substrate rotating at a constant speed while scanning a developing solution ejecting nozzle at a constant rate (dynamic dispense method), or the like may be applied. The time for carrying out the pattern development is not particularly limited, but is preferably 10 seconds to 90 seconds.

After the step of carrying out the development, a step of stopping the development by the replacement with another solvent may be performed.

A step of rinsing the resist film with a rinsing solution containing an organic solvent is preferably provided after the development.

The rinsing solution used in the rinsing step after the development is not particularly limited as long as the rinsing solution does not dissolve the resist pattern cured by crosslinking. A solution containing a general organic solvent or water may be used as the rinsing solution. As the foregoing rinsing solution, it is preferable to use a rinsing solution containing at least one kind of organic solvent selected from a hydrocarbon-based solvent, a ketone-based solvent, an ester-based solvent, an alcohol-based solvent, an amide-based solvent, and an ether-based solvent. More preferably, after the development, a step of rinsing the film by using a rinsing solution containing at least one kind of organic solvent selected from the group consisting of a ketone-based solvent, an ester-based solvent, an alcohol-based solvent and an amide-based solvent is carried out. Still more preferably, after the development, a step of rinsing the film by using a rinsing solution containing an alcohol-based solvent or an ester-based solvent is carried out. Even further preferably, after the development, a step of rinsing the film by using a rinsing solution containing a monohydric alcohol is carried out. Particularly preferably, after the development, a step of rinsing the film by using a rinsing solution containing a monohydric alcohol having 5 or more carbon atoms is carried out. The time for rinsing the pattern is not particularly limited, but is preferably 10 seconds to 90 seconds.

Here, examples of the monohydric alcohol used in the rinsing step after the development include a linear, branched or cyclic monohydric alcohol. For example, those described in International Publication No. WO 2013/24778 can be used. As a particularly preferable monohydric alcohol having 5 or more carbon atoms, 1-hexanol, 2-hexanol, 4-methyl-2-pentanol, 1-pentanol, 3-methyl-1-butanol or the like can be used.

A plurality of these components may be mixed, or the component may be used by mixing the component with an organic solvent other than those described above.

The water content ratio in the rinsing solution is preferably 10% by mass or less, more preferably 5% by mass or less, and particularly preferably 3% by mass or less. By setting the water content ratio to 10% by mass or less, better development characteristics can be obtained.

The vapor pressure at 20°C of the rinsing solution used after the development is preferably 0.05 kPa or more and 5 kPa or less, still more preferably 0.1 kPa or more and 5 kPa or less, and most preferably 0.12 kPa or more and 3 kPa or less. By setting the vapor pressure of the rinsing solution to 0.05 kPa or more and 5 kPa or less, the temperature uniformity in the wafer surface is further enhanced and moreover, swelling due to permeation of the rinsing solution is further inhibited. As a result, the dimensional uniformity in the wafer surface is further improved.

The rinsing solution may also be used after adding an appropriate amount of a surfactant thereto.

In the rinsing step, the wafer after the development is rinsed using the above organic solvent containing rinsing solution. The method for the rinsing treatment is not particularly limited. However, for example, a method for continuously ejecting a rinsing solution on a substrate spinning at a constant speed (spin coating method), a method for dipping a substrate in a bath filled with a rinsing solution for a fixed time (dipping method), and a method for spraying a rinsing solution on a substrate surface (spraying method), or the like can be applied. Above all, it is preferable to carry out the rinsing treatment by the spin coating method and after the rinsing, spin the substrate at a rotational speed of 2,000 rpm to 4,000 rpm, to remove the rinsing solution from the substrate surface.

After forming the resist pattern, a pattern wiring substrate is obtained by etching. Etching can be carried out by a publicly known method such as dry etching using plasma gas, and wet etching with an alkaline solution, a cupric chloride solution, a ferric chloride solution or the like.

After forming the resist pattern, plating can also be carried out. Examples of the above plating method include copper plating, solder plating, nickel plating and gold plating.

The remaining resist pattern after the etching can be stripped by a publicly known method such as dry stripping and wet stripping. As the dry stripping, the remaining resist pattern can be stripped through photo-excited ashing in which ozone or oxygen gas is irradiated with light such as ultraviolet and resist stripping is performed using a chemical reaction between the gas and the resist, or through plasma ashing in which a gas is made into plasma with high frequency and the resist is stripped by utilizing that plasma. As the wet stripping, the remaining resist pattern can be stripped with a resist stripper or an organic solvent. Examples of the above organic solvent include PGMEA (propylene glycol monomethyl ether acetate), PGME (propylene glycol monomethyl ether) and EL (ethyl lactate). Examples of the above stripping method include a dipping method and a spraying method. In addition, a wiring substrate having a resist pattern formed thereon may be a multilayer wiring substrate, and may have a small diameter through hole.

The wiring substrate obtained in the present embodiment can also be formed by a method for forming a resist pattern, then depositing a metal in vacuum, and subsequently dissolving the resist pattern in a solution, i.e., a liftoff method.

Also, in the present embodiment, in the same way as the resist pattern formation method mentioned above, an insulating film can be formed through the steps of: forming a photoresist layer on a substrate, using the composition of the present embodiment; irradiating a predetermined region of the photoresist layer formed on the substrate with radiation; and developing the photoresist layer after the radiation irradiation.

### Examples

The present embodiment will be described in more detail with reference to synthesis examples and examples below. However, the present embodiment is not limited to these examples by any means.

### [Molecular weight]

With respect to the molecular weight of a compound, by carrying out gel permeation chromatography (GPC) analysis, the weight average molecular weight (Mw), number average molecular weight (Mn) and dispersibility (Mw/Mn) in terms of polystyrene were determined.
Apparatus: Shodex GPC-101 model (manufactured by Showa Denko K.K.)
Column: KF-80M × 3
Eluent: 1 ml/min THF
Temperature: 40°C

### [Structure of compound]

The structure of a compound was confirmed by ¹H-NMR measurement using "Advance 600II spectrometer" manufactured by Bruker Corp. under the following conditions.
Frequency: 400 mhz
Solvent: d6-DMSO
Internal standard: TMS
Measurement temperature: 23°C

### [Base material (A)]

### (Synthesis of acrylic polymer 1)

4.15 g of 2-methyl-2-methacryloyloxyadamantane, 3.00 g of methacryloyloxy-y-butyrolactone, 2.08 g of 3-hydroxy-1-adamantyl methacrylate and 0.38 g of azobisisobutyronitrile were dissolved in 80 mL of tetrahydrofuran to prepare a reaction solution. This reaction solution was polymerized for 22 hours with the reaction temperature kept at 63°C in a nitrogen atmosphere. Then, the reaction solution was added dropwise into 400 mL of n-hexane. The obtained product resin was solidified and purified, and the resulting white powder was filtered and then dried overnight at 40°C under reduced pressure to obtain an acrylic polymer 1 represented by the following formula (11).

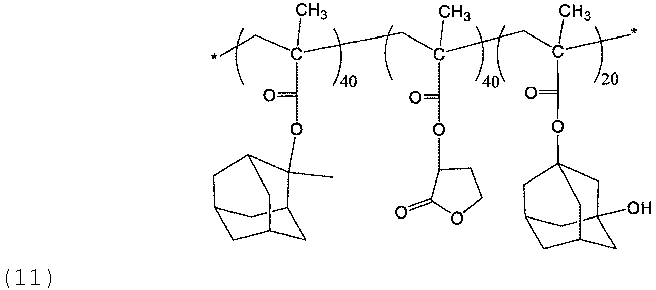

In the above formula (11), "40", "40", and "20" represent the ratio of each constituent unit and do not represent a block copolymer.

### (Production of polyphenols (B))

Polyphenols (B) will be shown in the following Table. Each synthesis was carried out with reference to International Publication No. WO 2013/024778, International Publication No. WO 2015/137486 or International Publication No. WO 2016/158458.

### - Synthesis of NF7177C -

Following Example 1 of International Publication No. WO 2015/137486, a container (internal capacity: 200 mL) equipped with a stirrer, a condenser tube and a burette was prepared. To this container, 30 g (161 mmol) of 4,4-biphenol (a reagent manufactured by Tokyo Chemical Industry Co., Ltd.), 15 g (82 mmol) of 4-biphenylaldehyde (manufactured by Mitsubishi Gas Chemical Company, Inc.), and 100 mL of butyl acetate were added, and 3.9 g (21 mmol) of p-toluenesulfonic acid (a reagent manufactured by Kanto Chemical Co., Inc.) was added to prepare a reaction liquid. This reaction liquid was stirred at 90°C for 3 hours and reacted. Next, the reaction liquid was concentrated. The reaction product was precipitated by the addition of 50 g of heptane. After cooling to room temperature, the precipitates were separated by filtration. The solid matter obtained by filtration was dried to obtain 7.5 g of the objective compound (NF7177C).

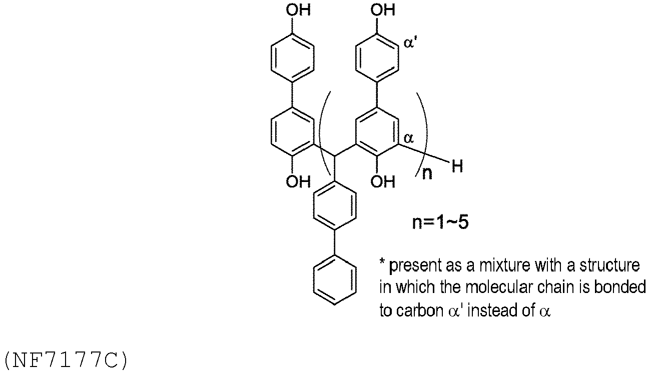

### - Synthesis of NF0197C -

Following Synthesis Example 15 of International Publication No. WO 2013/024778, to a container (internal capacity: 100 ml) equipped with a stirrer, a condenser tube, and a burette, 3.20 g (20 mmol) of 2,6-naphthalenediol (a reagent manufactured by Sigma-Aldrich) and 1.82 g (10 mmol) of 4-biphenylcarboxaldehyde (manufactured by Mitsubishi Gas Chemical Company, Inc.) were added with 30 ml of methyl isobutyl ketone, and 5 ml of 95% sulfuric acid was added. The reaction liquid was stirred at 100°C for 6 hours and reacted. Next, the reaction liquid was concentrated. The reaction product was precipitated by the addition of 50 g of pure water. After cooling to room temperature, the precipitates were separated by filtration.

The obtained solid matter was filtered and then dried. Subsequently, the solid matter was separated and purified by column chromatography to obtain 3.05 g of the objective compound (NF0197) represented by the following formula.

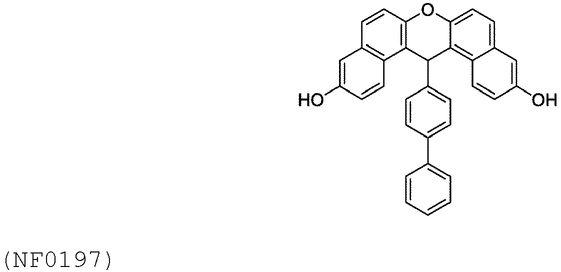

### - Synthesis of NF71A7 -

In the same manner as the synthesis of NF0197 mentioned above except that 2,6-naphthalenediol was changed to "o-phenylphenol", 2.35 g of the objective compound (NF71A7) represented by the following formula was obtained.

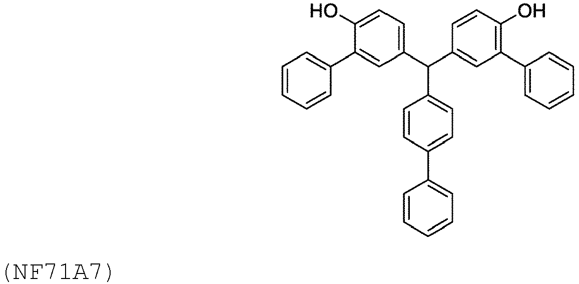

### - Synthesis of NF91A7 -

In the same manner as the synthesis of NF71A7 mentioned above except that 4-biphenylcarboxaldehyde was further changed to "acetylbiphenyl", 1.05 g of the objective compound (NF91A7) represented by the following formula was obtained.

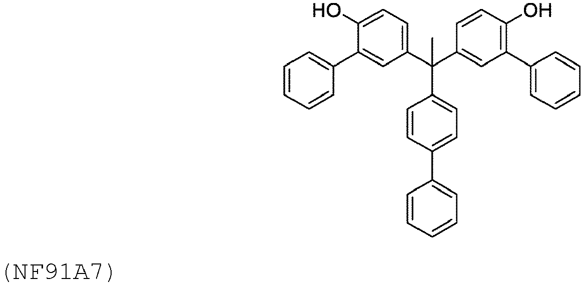

### - Synthesis of MGR214 -

Following Synthesis Working Example 1 of International Publication No. WO 2016/158458, a container (internal capacity: 200 mL) equipped with a stirrer, a condenser tube and a burette was prepared. To this container, 30 g (161 mmol) of 4,4-biphenol (a reagent manufactured by Tokyo Chemical Industry Co., Ltd.), 15 g (65 mmol) of 4-iodobenzaldehyde (a reagent manufactured by Tokyo Chemical Industry Co., Ltd.), and 100 mL of 4-butyrolactone were added, and 3.9 g (21 mmol) of p-toluenesulfonic acid (a reagent manufactured by Kanto Chemical Co., Inc.) was added to prepare a reaction liquid. This reaction liquid was stirred at 90°C for 3 hours and reacted. Next, the reaction liquid was concentrated. The reaction product was precipitated by the addition of 50 g of heptane. After cooling to room temperature, the precipitates were separated by filtration. The solid matter obtained by filtration was dried and then separated and purified by column chromatography to obtain 4.2 g of the objective compound (MGR214) represented by the following formula. The following peaks were found by NMR measurement performed on the obtained compound (MGR214) under the above measurement conditions, and the compound was confirmed to have a chemical structure of the following formula (MGR214) .
δ (ppm) 9.67-9.68 (4H, -O-H), 6.83-7.63 (18H, Ph-H), 5.48 (1H, C-H)

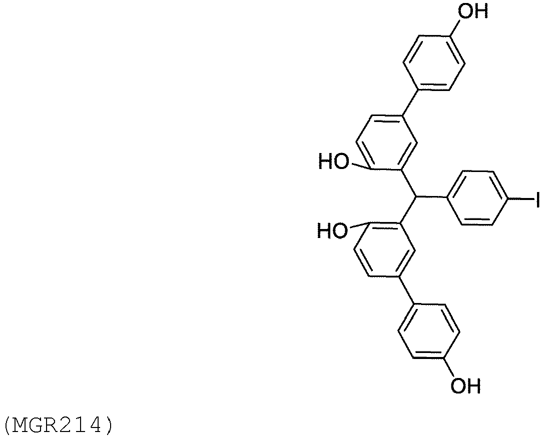

### - Synthesis of MGR218 -

In a container (internal capacity: 300 mL) equipped with a stirrer, a condenser tube, and a burette, 35 g (188 mmol) of 4,4-biphenol (a reagent manufactured by Tokyo Chemical Industry Co., Ltd.) was added to 150 g of 1-methoxy-2-propanol (PGME), and the resultant mixture was stirred at 90°C under nitrogen circulation. Furthermore, under nitrogen circulation, 15 g (65 mmol) of 4-iodobenzaldehyde (a reagent manufactured by Tokyo Chemical Industry Co., Ltd.) and 0.7 ml (13 mmol) of sulfuric acid were added to prepare a reaction liquid. After stirring this reaction liquid at 125°C for 6 hours, a saturated sodium bicarbonate solution was added to terminate the reaction. PGME was distilled off under reduced pressure and O-xylene was added to separate an insoluble matter. Then, butyl acetate was added to the filtrate, which was then washed with an aqueous sodium carbonate solution. Next, an aqueous sodium hydroxide solution was added to extract the target compound into the aqueous phase, and the aqueous phase was neutralized with aqueous hydrochloric acid. Then, the organic phase extracted with ethyl acetate was washed with saturated brine and the solid matter obtained after concentration under reduced pressure was dried, thereby obtaining 22 g of the objective compound (MGR218) represented by the following formula. The following peaks were found by NMR measurement performed on the obtained compound (MGR218) under the above measurement conditions, and the compound was confirmed to have a chemical structure of the following formula (MGR218).
δ (ppm) 7.2-9.6 (10H, -O-H), 6.7-7.63 (48H, Ph-H), 6.08 (4H, C-H)
As a result of measuring the molecular weight of the obtained compound by the above method, Mn was 1199 and Mw was 1291.

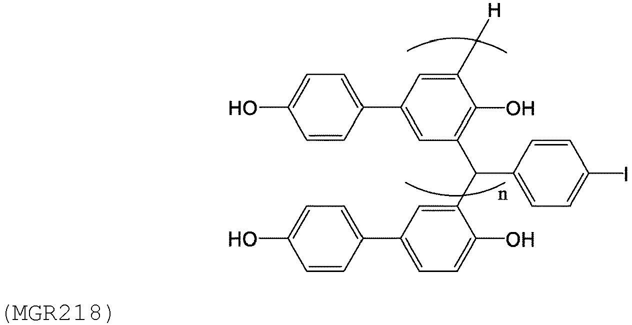

### - Synthesis of MGR219 -

In a container (internal capacity: 200 mL) equipped with a stirrer, a condenser tube, and a burette, 25.0 g (204.7 mmol) of 2,6-dimethylphenol (a reagent manufactured by Tokyo Chemical Industry Co., Ltd.), 25.0 g (107.7 mmol) of 4-iodobenzaldehyde (a reagent manufactured by Tokyo Chemical Industry Co., Ltd.), and 20 mL of 1-methoxy-2-propanol were placed, and 5.3 g (53.9 mmol) of sulfuric acid was added to prepare a reaction liquid. This reaction liquid was stirred at 90°C for 6 hours and reacted. After the reaction finished, 1L of pure water was added to the reaction liquid, and sodium bicarbonate was added under ice cooling such that the pH was adjusted to 7 to 8. Extraction with ethyl acetate was performed, followed by concentration, to obtain a solution. The obtained solution was separated and purified by column chromatography to obtain 24.9 g of the objective compound (MGR219) represented by the following formula. The following peaks were found by NMR measurement performed on the obtained compound (MGR219) under the above measurement conditions, and the compound was confirmed to have a chemical structure of the following formula (MGR219).
δ (ppm) 8.1 (2H, -O-H), 6.5-7.7 (8H, Ph-H), 5.2 (1H, C-H), 2.1 (12H, CH₃)

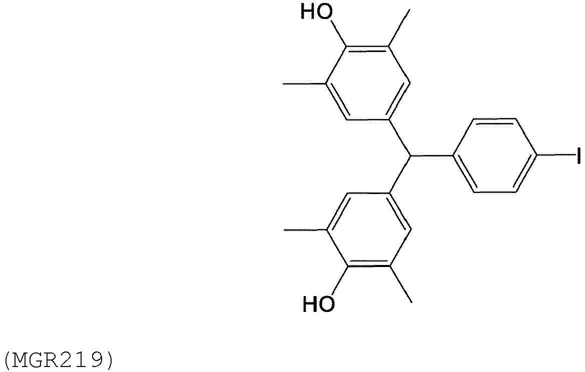

### - Synthesis of MGR219-A -

In a container (internal capacity: 200 mL) equipped with a stirrer, a condenser tube, and a burette, 25.0 g (204.7 mmol) of 2,6-dimethylphenol (a reagent manufactured by Tokyo Chemical Industry Co., Ltd.), 40.2 g (107.7 mmol) of 2-hydroxy-3,5-diiodobenzaldehyde (a reagent manufactured by Tokyo Chemical Industry Co., Ltd.), and 20 mL of 1-methoxy-2-propanol were placed, and 5.3 g (53.9 mmol) of sulfuric acid was added to prepare a reaction liquid. This reaction liquid was stirred at 90°C for 6 hours and reacted. After the reaction finished, 1L of pure water was added to the reaction liquid, and sodium bicarbonate was added under ice cooling such that the pH was adjusted to 7 to 8. Extraction with ethyl acetate was performed, followed by concentration, to obtain a solution. The obtained solution was separated and purified by column chromatography to obtain 25.2 g of the objective compound (MGR219-A) represented by the following formula. The following peaks were found by NMR measurement performed on the obtained compound (MGR219-A) under the above measurement conditions, and the compound was confirmed to have a chemical structure of the following formula (MGR219-A) .
δ (ppm) 8.1-9.5 (3H, -O-H), 6.5-7.9 (6H, Ph-H), 5.2 (1H, C-H), 2.1 (12H, CH₃)

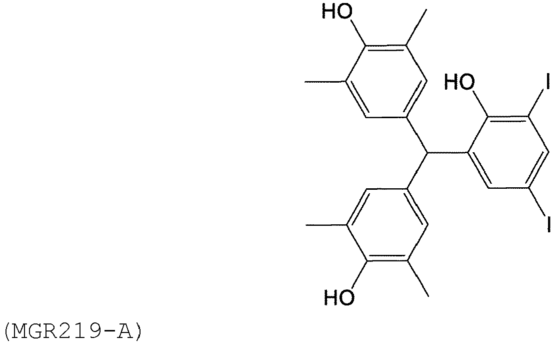

### - Synthesis of MGR219-B -

In a container (internal capacity: 200 mL) equipped with a stirrer, a condenser tube, and a burette, 25.0 g (204.7 mmol) of 2,6-dimethylphenol (a reagent manufactured by Tokyo Chemical Industry Co., Ltd.), 40.2 g (107.7 mmol) of 4-hydroxy-3,5-diiodobenzaldehyde (a reagent manufactured by Tokyo Chemical Industry Co., Ltd.), and 20 mL of 1-methoxy-2-propanol were placed, and 5.3 g (53.9 mmol) of sulfuric acid was added to prepare a reaction liquid. This reaction liquid was stirred at 90°C for 6 hours and reacted. After the reaction finished, 1L of pure water was added to the reaction liquid, and sodium bicarbonate was added under ice cooling such that the pH was adjusted to 7 to 8. Extraction with ethyl acetate was performed, followed by concentration, to obtain a solution. The obtained solution was separated and purified by column chromatography to obtain 25.2 g of the objective compound (MGR219-B) represented by the following formula. The following peaks were found by NMR measurement performed on the obtained compound (MGR219-B) under the above measurement conditions, and the compound was confirmed to have a chemical structure of the following formula (MGR219-B) .
δ (ppm) 8.1-9.5 (3H, -O-H), 6.5-7.7 (6H, Ph-H), 5.2 (1H, C-H), 2.1 (12H, CH₃)

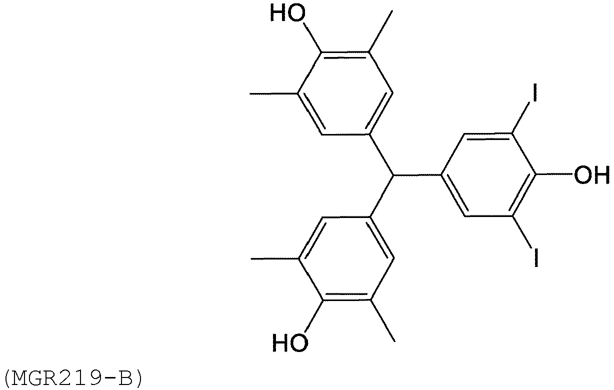

### - Synthesis of MGR211 -

In a container (internal capacity: 200 mL) equipped with a stirrer, a condenser tube, and a burette, 32.78 g (204.7 mmol) of 2,7-dihydroxynaphthalene (a reagent manufactured by Tokyo Chemical Industry Co., Ltd.), 25.0 g (107.7 mmol) of 4-iodobenzaldehyde (a reagent manufactured by Tokyo Chemical Industry Co., Ltd.), and 20 mL of 1-methoxy-2-propanol were placed, and 5.3 g (53.9 mmol) of sulfuric acid was added to prepare a reaction liquid. This reaction liquid was stirred at 90°C for 6 hours and reacted. After the reaction finished, 1L of pure water was added to the reaction liquid, and sodium bicarbonate was added under ice cooling such that the pH was adjusted to 7 to 8. Extraction with ethyl acetate was performed, followed by concentration, to obtain a solution. The obtained solution was separated and purified by column chromatography to obtain 30.9 g of the objective compound (MGR211) represented by the following formula. The following peaks were found by NMR measurement performed on the obtained compound (MGR211) under the above measurement conditions, and the compound was confirmed to have a chemical structure of the following formula (MGR211) .
δ (ppm) 9.22 (2H, -O-H), 6.8-7.83 (14H, Ph-H), 5.34 (1H, C-H)

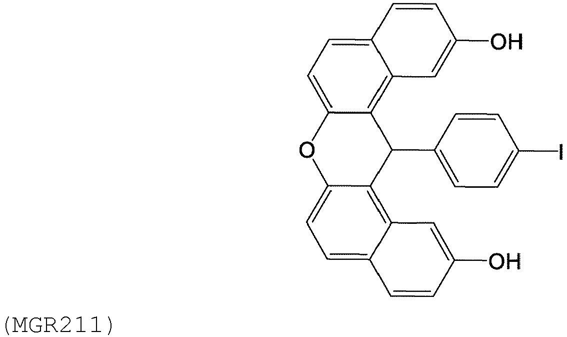

### - Synthesis of MGR216 -

In a container (internal capacity: 500 mL) equipped with a stirrer, a condenser tube, and a burette, 42.8 g (230 mmol) of 4,4'-biphenol (a reagent manufactured by Tokyo Chemical Industry Co., Ltd.), 21.5 g (57.5 mmol) of 3,5-diiodosalicylaldehyde (a reagent manufactured by Tokyo Chemical Industry Co., Ltd.), and 428 mL of γ-butyrolactone were placed, and 5.8 g (58 mmol) of sulfuric acid was added to prepare a reaction liquid. This reaction liquid was stirred at 90°C for 56 hours and reacted. After the reaction finished, 1L of pure water was added to the reaction liquid, which was then neutralized with sodium hydroxide. Extraction with ethyl acetate was performed, followed by concentration, to obtain a solution. The obtained solution was separated and purified by column chromatography to obtain 10 g of the objective compound (MGR216) represented by the following formula. The following peaks were found by NMR measurement performed on the obtained compound (MGR216) under the above measurement conditions, and the compound was confirmed to have a chemical structure of the following formula (MGR216).
δ (ppm) 9.4 (4H, -O-H), 8.9 (1H, -O-H), 6.2-7.8 (16H, Ph-H), 6.3 (1H, C-H)

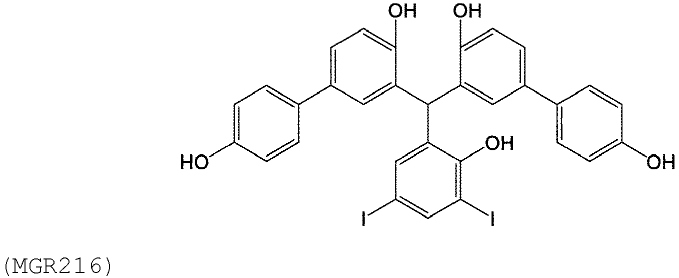

### - Synthesis of MGR219-MeBOC -

In a container (internal capacity: 500 mL) equipped with a stirrer, a condenser tube, and a burette, 3.7 g (8.1 mmol) of the compound (MGR219) obtained as described above, 5.4 g (27 mmol) of t-butyl bromoacetate (manufactured by Sigma-Aldrich), and 100 mL of acetone were placed, and 3.8 g (27 mmol) of potassium carbonate (manufactured by Sigma-Aldrich) and 0.8 g of 18-crown-6 were added. The contents were stirred for 3 hours under reflux and reacted. Next, after the reaction finished, the reaction liquid was concentrated, and the reaction product was precipitated by adding 100 g of pure water to the concentrate, cooled to room temperature, and then filtered to separate solid matter.

The obtained solid matter was dried, and then separated and purified by column chromatography to obtain 1.6 g of the following formula (MGR219-MeBOC).

The following peaks were found by NMR measurement performed on the obtained compound (MGR219-MeBOC) under the above measurement conditions, and the compound was confirmed to have a chemical structure of the following formula (MGR219-MeBOC).
¹H-NMR (d6-DMSO) : δ (ppm) 1.4 (18H, O-C-CH₃), 2.1 (12H, Ph-CH₃), 4.9 (4H, O-CH₂-C), 5.2 (1H, C-H), 6.5-7.9 (8H, Ph-H)

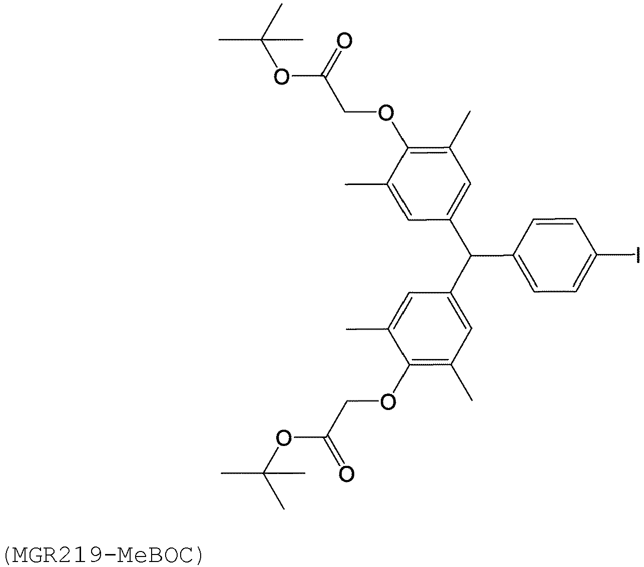

### [Examples 1 to 14 and Comparative Example 1]

Compositions for lithography were each prepared according to the composition shown in Table 1 below. Next, a silicon substrate was spin coated with each of these compositions for lithography, and then baked at 110°C for 60 seconds to prepare each resist film with a film thickness of 50 nm. The following acid generating agent, acid diffusion controlling agent and organic solvent were used.

Acid generating agent: triphenylsulfonium nonafluoromethanesulfonate (TPS-109) manufactured by Midori Kagaku Co., Ltd.

Acid diffusion controlling agent: tri-n-octylamine (TOA) manufactured by Kanto Chemical Co., Inc.

Organic solvent: propylene glycol monomethyl ether (PGME) manufactured by Kanto Chemical Co., Inc.

**[Table 1]**

| | Resist base material (A) (parts by mass) | Polyphenol compound (B) (parts by mass) | Acid generating agent (parts by mass) | Acid diffusion controlling agent (parts by mass) | Organic solvent (parts by mass) |
|---|---|---|---|---|---|
| Example 1 | Acrylic polymer 1 | NF7177C | TPS-109 | TOA | PGME |
| | 4.5 | 0.5 | 1 | 0.1 | 100 |
| Example 2 | Acrylic polymer 1 | NF0197 | TPS-109 | TOA | PGME |
| | 4.5 | 0.5 | 1 | 0.1 | 100 |
| Example 3 | Acrylic polymer 1 | NF71A7 | TPS-109 | TOA | PGME |
| | 4.5 | 0.5 | 1 | 0.1 | 100 |
| Example 4 | Acrylic polymer 1 | NF91A7 | TPS-109 | TOA | PGME |
| | 4.5 | 0.5 | 1 | 0.1 | 100 |
| Example 5 | Acrylic polymer 1 | MGR214 | TPS-109 | TOA | PGME |
| | 4.5 | 0.5 | 1 | 0.1 | 100 |
| Example 6 | Acrylic polymer 1 | MGR218 | TPS-109 | TOA | PGME |
| | 4.5 | 0.5 | 1 | 0.1 | 100 |
| Example 7 | Acrylic polymer 1 | MGR219 | TPS-109 | TOA | PGME |
| | 4.5 | 0.5 | 1 | 0.1 | 100 |
| Example 8 | Acrylic polymer 1 | MGR219-A | TPS-109 | TOA | PGME |
| | 4.5 | 0.5 | 1 | 0.1 | 100 |
| Example 9 | Acrylic polymer 1 | MGR219-B | TPS-109 | TOA | PGME |
| | 4.5 | 0.5 | 1 | 0.1 | 100 |
| Example 10 | Acrylic polymer 1 | MGR211 | TPS-109 | TOA | PGME |
| | 4.5 | 0.5 | 1 | 0.1 | 100 |
| Example 11 | Acrylic polymer 1 | MGR216 | TPS-109 | TOA | PGME |
| | 4.5 | 0.5 | 1 | 0.1 | 100 |
| Example 12 | Acrylic polymer 1 | MGR216 | TPS-109 | - | PGME |
| | 4.5 | 0.5 | 1 | - | 100 |
| Example 13 | Acrylic polymer 1 | MGR219-MeBOC | TPS-109 | TOA | PGME |
| | 4.5 | 0.5 | 1 | 0.1 | 100 |
| Example 14 | Acrylic polymer 1 | MGR219-MeBOC | TPS-109 | - | PGME |
| | 4.5 | 0.5 | 1 | - | 100 |
| Comparative | Acrylic polymer 1 5- | None | TPS-109 | TOA | PGME |
| Example 1 | | - | 1 | 0.1 | 100 |

### [Examples 15 to 28 and Comparative Example 2]

At first, a silicon substrate was spin coated with each of the compositions of Examples 1 to 14 and Comparative Example 1, and then baked at 110°C for 90 seconds, thereby obtaining resist films of Examples 15 to 28 and Comparative Example 2 with a film thickness of 50 nm.

Next, "film defects" and "etching test (etching resistance)" were carried out under the following conditions, and evaluation was performed according to the following evaluation criteria. The evaluation results are shown in Table 2.

### [Evaluation of film defects]

Each of the resist films obtained in Examples and Comparative Example was observed with an optical microscope, and the number of defects in the film was measured. As the criteria, those in which the number of defects is superior to Comparative Example 2 (the number of defects is smaller) was evaluated to be "A", and those in which the number of defects is equivalent to or inferior to Comparative Example 2 (the number of defects is larger) was evaluated to be "C". The results are shown in Table 2.

### [Etching test]

Etching apparatus: RIE-10NR manufactured by Samco International, Inc.
Output: 50 W
Pressure: 20 Pa
Time: 2 min
Etching gas
Ar gas flow rate:CF₄ gas flow rate: O₂ gas flow rate = 50:5:5 (sccm)

For each of the films obtained in Examples and Comparative Example, the etching test was carried out under the conditions mentioned above, and the etching rate upon that time was measured. Then, the etching resistance was evaluated according to the following evaluation criteria on the basis of the etching rate of an underlayer film prepared by using a novolac ("PSM4357" manufactured by Gunei Chemical Industry Co., Ltd.).

### [Evaluation criteria]

A: The etching rate was less than -5% as compared with the underlayer film of novolac.
B: The etching rate was -5% to +5% as compared with the underlayer film of novolac.
C: The etching rate was more than +5% as compared with the underlayer film of novolac.

### [Examples 29 to 42 and Comparative Example 3]

Next, a silicon substrate was spin coated with each of the compositions of Examples 1 to 14 and Comparative Example 1, and then baked at 110°C for 90 seconds to prepare their respective resist films with a film thickness of 50 nm. Next, the resist films were exposed with a 55 nm L/S (1:1) and 80 nm L/S (1:1) pattern by using an electron beam lithography system (manufactured by ELIONIX INC.; ELS-7500, 50 keV). After the exposure, the resist films were baked (PEB) at 110°C for 90 seconds and developed with an aqueous 2.38 mass% tetramethylammonium hydroxide (TMAH) solution for 60 seconds, thereby obtaining positive type resist patterns of Examples 19 to 42 and Comparative Example 3.

### [Evaluation of pattern shape and sensitivity]

For each of Examples 29 to 42 and Comparative Example 3, the shape of the obtained 55 nm L/S (1:1) and 80 nm L/S (1:1) resist pattern was observed by using an electron microscope (S-4800) manufactured by Hitachi, Ltd. With respect to the "resist pattern shape" after the development, those having no pattern collapse and good rectangularity were evaluated to be "A", those having no pattern collapse and having round top in some parts thereof were evaluated to be "B", and the others were evaluated to be "C". Furthermore, the smallest electron beam energy quantity capable of lithographing a good pattern shape was set as "sensitivity", and those in which the sensitivity is superior to Comparative Example 3 by 10% or more were evaluated to be "S", those in which the sensitivity is superior by less than 10% were evaluated to be "A", and those in which the sensitivity is equivalent to or inferior to Comparative Example 3 were evaluated to be "C". The results are shown in Table 2.

**[Table 2]**

| | Composition for resist film formation | Film defects | Etching resistance | Resist pattern shape after development | Sensitivity |
|---|---|---|---|---|---|
| Example 15 | Composition described in Example 1 | A | A | - | - |
| Example 16 | Composition described in Example 2 | A | A | - | - |
| Example 17 | Composition described in Example 3 | A | A | - | - |
| Example 18 | Composition described in Example 4 | A | A | - | - |
| Example 19 | Composition described in Example 5 | A | A | - | - |
| Example 20 | Composition described in Example 6 | A | A | - | - |
| Example 21 | Composition described in Example 7 | A | A | - | - |
| Example 22 | Composition described in Example 8 | A | A | | |
| Example 23 | Composition described in Example 9 | A | A | | |
| Example 24 | Composition described in Example 10 | A | A | - | - |
| Example 25 | Composition described in Example 11 | A | A | - | - |
| Example 26 | Composition described in Example 12 | A | A | - | - |
| Example 27 | Composition described in Example 13 | A | A | - | - |
| Example 28 | Composition described in Example 14 | A | A | - | - |
| Example 29 | Composition described in Example 1 | - | - | A | A |
| Example 30 | Composition described in Example 2 | - | - | A | A |
| Example 31 | Composition described in Example 3 | - | - | A | A |
| Example 32 | Composition described in Example 4 | - | - | A | A |
| Example 33 | Composition described in Example 5 | - | - | A | S |
| Example 34 | Composition described in Example 6 | - | - | A | S |
| Example 35 | Composition described in Example 7 | - | - | A | S |
| Example 36 | Composition described in Example 8 | | | A | S |
| Example 37 | Composition described in Example 9 | | | A | S |
| Example 38 | Composition described in Example 10 | - | - | A | S |
| Example 39 | Composition described in Example 11 | - | - | A | S |
| Example 40 | Composition described in Example 12 | - | - | B | S |
| Example 41 | Composition described in Example 13 | - | - | A | S |
| Example 42 | Composition described in Example 14 | - | - | A | S |
| Comparative Example 2 | Composition described in Comparative Example 1 | C | C | - | - |
| Comparative Example 3 | Composition described in Comparative Example 1 | - | - | C | C |

As mentioned above, the composition of the present embodiment can be used for a resist composition or the like that is capable of reducing film defects, has high sensitivity and high etching resistance, and provides a good resist pattern shape.

Therefore, the lithography composition and the pattern formation method can be utilized widely and effectively in a variety of applications that require such performances.

The disclosure of Japanese Patent Application No. 2018-015335 filed on January 31, 2018 is incorporated herein by reference in its entirety.

All literatures, patent applications, and technical standards described herein are incorporated herein by reference to the same extent as if each individual literature, patent application, or technical standard is specifically and individually indicated to be incorporated by reference.

## Claims

1. A composition comprising a base material (A) and a polyphenol compound (B), wherein a mass ratio between the base material (A) and the polyphenol compound (B) is 5:95 to 95:5.

2. The composition according to claim 1, wherein the base material (A) is selected from the group consisting of a phenol novolac resin, a cresol novolac resin, a hydroxystyrene resin, a (meth)acrylic resin, a hydroxystyrene-(meth)acrylic copolymer, a cycloolefin-maleic anhydride copolymer, a cycloolefin, a vinyl ether-maleic anhydride copolymer and an inorganic resist material having a metallic element, and a derivative thereof.

3. The composition according to claim 1 or 2, wherein the polyphenol compound (B) is selected from a compound represented by the following formula (1) and a resin having a structure represented by the following formula (2) : 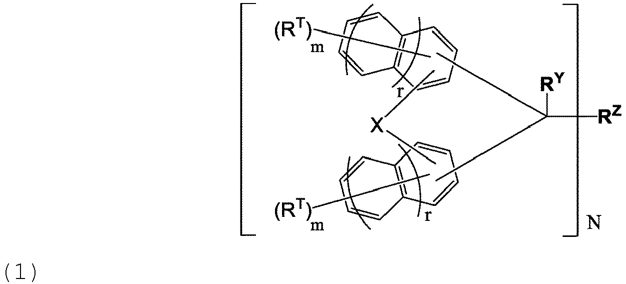 wherein R^{Y} is a hydrogen atom, an alkyl group having 1 to 30 carbon atoms and optionally having a substituent, or an aryl group having 6 to 30 carbon atoms and optionally having a substituent;
R^{Z} is an N-valent group having 1 to 60 carbon atoms and optionally having a substituent, or a single bond;
each R^{T} is independently an alkyl group having 1 to 30 carbon atoms and optionally having a substituent, an aryl group having 6 to 30 carbon atoms and optionally having a substituent, an alkenyl group having 2 to 30 carbon atoms and optionally having a substituent, an alkynyl group having 2 to 30 carbon atoms and optionally having a substituent, an alkoxy group having 1 to 30 carbon atoms and optionally having a substituent, a halogen atom, a nitro group, an amino group, a carboxylic acid group, a crosslinkable group, a dissociation group, a thiol group, or a hydroxy group (provided that at least one R^{T} contains a crosslinkable group, a dissociation group or a hydroxy group), wherein the alkyl group, the aryl group, the alkenyl group, the alkynyl group and the alkoxy group each optionally contain an ether bond, a ketone bond or an ester bond;
X is an oxygen atom, a sulfur atom or not a crosslink;
each m is independently an integer of 0 to 9 (provided that at least one m is an integer of 1 to 9);
N is an integer of 1 to 4 (provided that when N is an integer of 2 or larger, N structural formulas within the parentheses [ ] are the same or different); and
each r is independently an integer of 0 to 2, and 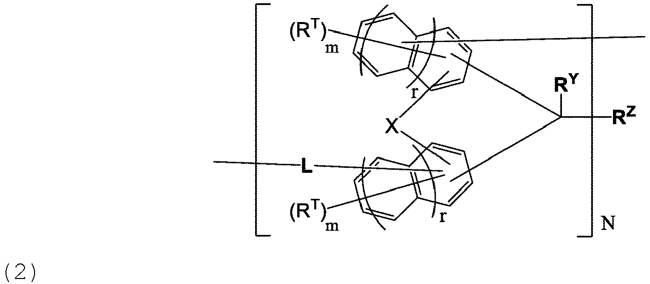 wherein L is an alkylene group having 1 to 30 carbon atoms and optionally having a substituent, an arylene group having 6 to 30 carbon atoms and optionally having a substituent, an alkoxylene group having 1 to 30 carbon atoms and optionally having a substituent, or a single bond, wherein the alkylene group, the arylene group and the alkoxylene group each optionally contain an ether bond, a ketone bond or an ester bond;
R^{Y} is a hydrogen atom, an alkyl group having 1 to 30 carbon atoms and optionally having a substituent, or an aryl group having 6 to 30 carbon atoms and optionally having a substituent;
R^{Z} is an N-valent group having 1 to 60 carbon atoms and optionally having a substituent, or a single bond;
each R^{T} is independently an alkyl group having 1 to 30 carbon atoms and optionally having a substituent, an aryl group having 6 to 30 carbon atoms and optionally having a substituent, an alkenyl group having 2 to 30 carbon atoms and optionally having a substituent, an alkynyl group having 2 to 30 carbon atoms and optionally having a substituent, an alkoxy group having 1 to 30 carbon atoms and optionally having a substituent, a halogen atom, a nitro group, an amino group, a carboxylic acid group, a crosslinkable group, a dissociation group, a thiol group, or a hydroxy group (provided that at least one R^{T} contains a crosslinkable group, a dissociation group or a hydroxy group), wherein the alkyl group, the aryl group, the alkenyl group, the alkynyl group and the alkoxy group each optionally contain an ether bond, a ketone bond or an ester bond;
X is an oxygen atom, a sulfur atom or not a crosslink;
each m is independently an integer of 0 to 9 (provided that at least one m is an integer of 1 to 9);
N is an integer of 1 to 4 (provided that when N is an integer of 2 or larger, N structural formulas within the parentheses [ ] are the same or different); and
each r is independently an integer of 0 to 2.

4. The composition according to any one of claims 1 to 3, wherein the mass ratio between the base material (A) and the polyphenol compound (B) is 51:49 to 95:5.

5. The composition according to any one of claims 1 to 4, further comprising an acid generating agent.

6. The composition according to any one of claims 1 to 5, further comprising a crosslinking agent.

7. The composition according to any one of claims 1 to 6, further comprising a solvent.

8. The composition according to any one of claims 1 to 7, wherein the composition is used in film formation for lithography.

9. The composition according to any one of claims 1 to 7, wherein the composition is used in film formation for resist.

10. The composition according to claim 3, wherein the compound represented by the above formula (1) is a compound represented by the following formula (3): 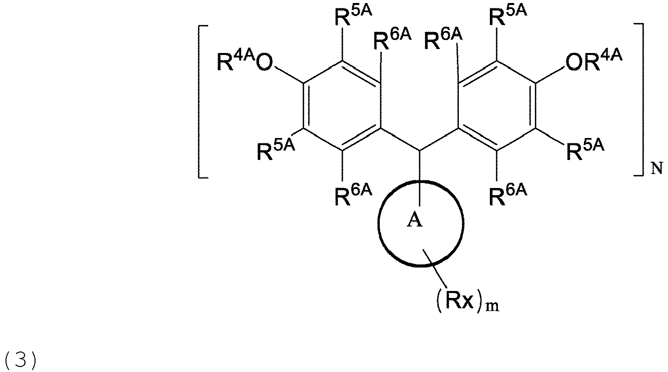 wherein A is an N-valent group having 1 to 60 carbon atoms and optionally having a substituent, and each Rx is independently an alkyl group having 1 to 30 carbon atoms and optionally having a substituent, an aryl group having 6 to 30 carbon atoms and optionally having a substituent, an alkenyl group having 2 to 30 carbon atoms and optionally having a substituent, an alkynyl group optionally having a substituent, an alkoxy group having 1 to 30 carbon atoms and optionally having a substituent, a halogen atom, a nitro group, an amino group, a carboxylic acid group, a crosslinkable group, a dissociation group, a thiol group, or a hydroxy group (provided that at least one Rx contains iodine); each R^{4A} is independently a dissociation group, a crosslinkable group or a hydrogen atom, each R^{5A} is independently an alkyl group having 1 to 30 carbon atoms and optionally having a substituent, an aryl group having 6 to 30 carbon atoms and optionally having a substituent, an alkenyl group having 2 to 30 carbon atoms and optionally having a substituent, an alkynyl group optionally having a substituent, an alkoxy group having 1 to 30 carbon atoms and optionally having a substituent, a halogen atom, a nitro group, an amino group, a carboxylic acid group, a crosslinkable group, a dissociation group, a thiol group, or a hydroxy group, and each R^{6A} is independently a hydrogen atom, an alkyl group having 1 to 30 carbon atoms and optionally having a substituent, an aryl group having 6 to 30 carbon atoms and optionally having a substituent, an alkenyl group having 2 to 30 carbon atoms and optionally having a substituent, an alkynyl group optionally having a substituent, an alkoxy group having 1 to 30 carbon atoms and optionally having a substituent, a halogen atom, a nitro group, an amino group, a carboxylic acid group, a crosslinkable group, a dissociation group, a thiol group, or a hydroxy group;
each m is independently an integer of 1 to 20; and N is as defined in the description of the above formula (1).

11. A method for forming a resist pattern, comprising the steps of: forming a photoresist layer on a substrate using the composition according to any one of claims 1 to 7 and 10; irradiating a predetermined region of the photoresist layer formed on the substrate with radiation; and developing the photoresist layer after the radiation irradiation.

12. A method for forming an insulating film, comprising the steps of: forming a photoresist layer on a substrate using the composition according to any one of claims 1 to 7 and 10; irradiating a predetermined region of the photoresist layer formed on the substrate with radiation; and developing the photoresist layer after the radiation irradiation.
